(19) Europäisches Patentamt
European Patent Office
Office européen des brevets

(11) EP 2 408 016 A1

(12) EUROPEAN PATENT APPLICATION
published in accordance with Art. 153(4) EPC

(43) Date of publication:
**18.01.2012 Bulletin 2012/03**

(21) Application number: **10750823.6**

(22) Date of filing: **09.03.2010**

(51) Int Cl.:
***H01L 31/042*** *(2006.01)*

(86) International application number:
**PCT/JP2010/053878**

(87) International publication number:
**WO 2010/104070 (16.09.2010 Gazette 2010/37)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **09.03.2009 JP 2009055070**
**09.03.2009 JP 2009055072**
**17.09.2009 JP 2009215170**
**17.09.2009 JP 2009215171**

(71) Applicant: **Sekisui Chemical Co., Ltd.**
**Osaka 530-8565 (JP)**

(72) Inventor: **ASUKA Masahiro**
**Mishima-gun**
**Osaka 618-8589 (JP)**

(74) Representative: **Merkle, Gebhard**
**ter Meer Steinmeister & Partner GbR**
**Mauerkircherstrasse 45**
**D-81679 München (DE)**

# (54) UNDERSIDE PROTECTIVE SHEET FOR SOLAR CELL, SOLAR CELL MODULE, AND GAS-BARRIER FILM

(57) The present invention provides an underside protective sheet for solar cell that is excellent in gas barrier properties to oxygen, moisture vapor, and the like. The underside protective sheet for solar cell of the present invention contains a composite base material 1 containing a polymer having a moisture vapor transmission rate of 10 g/$m^2$·day or less measured in accordance with JIS K7126 at 23°C with a relative humidity of 90% at a thickness of 100 μm, and plate-like inorganic particles, and a sol-gel layer 2 laminated and integrated on the composite base material 1 and formed by hardening one or more compounds selected from (A) a silicon compound represented by $R^1_nSi(OX)_{4-n}$ or a hydrolysate thereof, (B) an organometal compound represented by $M(OX)_m$ or a hydrolysate thereof, and (C) an alkali metal polysilicate.

Fig.1

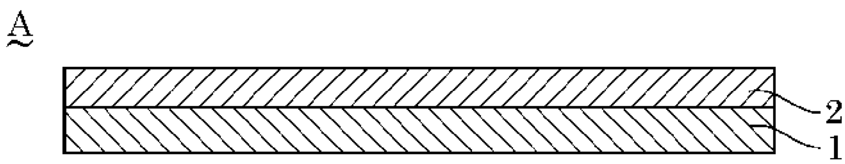


EP 2 408 016 A1

## Description

TECHNICAL FIELD

The present invention relates to an underside protective sheet for solar cell, a solar cell module, and a gas-barrier film.

BACKGROUND ART

A gas-barrier film is used as a packaging bag for food and pharmaceuticals for preventing the effects of oxygen, moisture vapor, and the like that cause quality change of the contents. In addition, in order to prevent elements used in a solar cell module, a liquid crystal display panel, an organic EL (electroluminescence) display panel, and the like, from deteriorating in performance by being exposed to oxygen or moisture vapor, a gas-barrier film is used as a part of the product construct or as a packaging material of those elements.

While a polyvinyl alcohol film and an ethylene-vinyl alcohol copolymer film are used as the gas-barrier film described above, there are problems that moisture vapor barrier properties are insufficient, and oxygen barrier properties are degraded under high humidity conditions.

Patent Document 1 suggests that an inorganic oxide such as silicon oxide is vapor-deposited on a film surface by a vacuum vapor-deposition method, as a method of manufacturing a gas-barrier film. The gas-barrier film produced by this manufacturing method has excellent gas barrier properties as compared to the above-described gas-barrier film.

However, there is a problem that, it is often the case that the vapor-deposited film formed by a vacuum vapor-deposition method has a pinhole, crack, and the like, and oxygen and moisture vapor go through a defect part such as a pinhole or crack of the vapor-deposited film, and consequently, gas barrier properties are still insufficient.

Incidentally, the above-described solar cell module is comprised by sealing a solar cell element such as a silicon semiconductor from the front and back sides by a sealing material such as an ethylene-vinyl acetate copolymer film, and also laminating and integrating a glass plate as a transparent protective member on the sealing material on the front side, and laminating and integrating an underside protective sheet for solar cell as a backsheet on the sealing material on the back side.

Patent Document 2 suggests a backsheet for a solar cell cover material made of a three-layer laminate of a hydrolysis resistant resin film, a metal oxide-deposited resin film and a white resin film.

However, in the above-described backsheet for a solar cell cover material, the metal oxide coating film is formed by a vapor-deposition method, and based on the above-described reason, there is a problem that gas barrier properties to oxygen, moisture vapor, and the like are insufficient.

PRIOR ART DOCUMENTS

PATENT DOCUMENTS

Patent Document 1 : Japanese Patent Laid-Open No. H08-176326
Patent Document 2 : Japanese Patent Laid-Open No. 2002-100788

SUMMARY OF THE INVENTION

PROBLEMS TO BE SOLVED BY THE INVENTION

The present invention provides an underside protective sheet for solar cell that is excellent in gas barrier properties to oxygen, moisture vapor, and the like, a solar cell module using this underside protective sheet for solar cell, and a gas-barrier film.

MEANS FOR SOLVING THE PROBLEMS

The underside protective sheet for solar cell A of the present invention is obtained by laminating and integrating a sol-gel layer 2 containing one or more compounds selected from (A) to (C) on a composite base material 1 containing a polymer having a moisture vapor transmission rate of 10 $g/m^2 \cdot day$ or less measured in accordance with JIS K7126 at 23°C with a relative humidity of 90% at a thickness of 100 $\mu m$, and plate-like inorganic particles, as shown in Fig. 1:

(A) a silicon compound represented by $R^1{}_nSi(OX)_{4-n}$ or a hydrolysate thereof
(B) an organometal compound represented by $M(OX)_m$ or a hydrolysate thereof
(C) an alkali metal polysilicate

wherein X independently represents an alkyl group having 1 to 6 carbon atoms or an acyl group having 1 to 6 carbon atoms, $R^1$ independently represents an alkyl group having 1 to 12 carbon atoms or a nonhydrolyzable functional group having polymerizability, M represents a metal atom, n represents 0 or an integer of 1 to 3, and m represents an integer of 2 to 4.

Examples of the polymer having a moisture vapor transmission rate of 10 $g/m^2 \cdot day$ or less measured in accordance with JIS K7126 at 23°C with a relative humidity of 90% at a thickness of 100 μm include polyolefin-based resins such as a polyethylene-based resin and a polypropylene-based resin, polyvinylidene chloride, polyimides, polycarbonates, polysulfones, liquid crystal polymers, and cycloolefin resins, and these may be used alone or may be used in combination of 2 or more kinds. Cycloolefin resins and liquid crystal polymers are preferable as the polymer since they are excellent in heat resistance and moisture vapor proof properties.

Examples of the liquid crystal polymer include a wholly aromatic liquid crystal polyester, a wholly aromatic liquid crystal polyimide, and a wholly aromatic liquid crystal polyesteramide, and a wholly aromatic liquid crystal polyester is preferable. The wholly aromatic liquid crystal polyester is a polyester referred to as a thermotropic liquid crystal polymer, and the representative examples include (1) resins obtained by reacting an aromatic dicarboxylic acid, an aromatic diol, and an aromatic hydroxycarboxylic acid, (2) resins obtained by reacting a combination of heterogeneous aromatic hydroxycarboxylic acids, (3) resins obtained by reacting an aromatic hydroxycarboxylic acid, an aromatic dicarboxylic acid, and an aliphatic diol, (4) resins obtained by reacting an aromatic dicarboxylic acid and an aromatic diol, and (5) resins obtained by reacting a polyester such as polyethylene terephthalate with an aromatic hydroxycarboxylic acid. The wholly aromatic liquid crystal polyester is normally a resin forming an anisotropic melt at a temperature of 400°C or less. Here, in place of an aromatic dicarboxylic acid, an aromatic diol, and an aromatic hydroxycarboxylic acid, ester derivatives thereof may be used. Furthermore, in an aromatic dicarboxylic acid, an aromatic diol, and an aromatic hydroxycarboxylic acid, a part of the aromatic ring may be substituted with a halogen atom, an alkyl group, an aryl group, or the like.

Specifically, the liquid crystal polyester includes type I [following formula (1)] synthesized from p-hydroxybenzoic acid (PHB), terephthalic acid, and 4,4'-biphenol, type II [following formula (2)] synthesized from PHB and 2,6-hydroxynaphthoic acid, and type III [following formula (3)] synthesized from PHB, terephthalic acid, and ethylene glycol. While any of type I to type III is fine, wholly aromatic liquid crystal polyesters (type I and type II) are preferable from the viewpoint of heat resistance, dimensional stability, and moisture vapor proof properties.

(1)

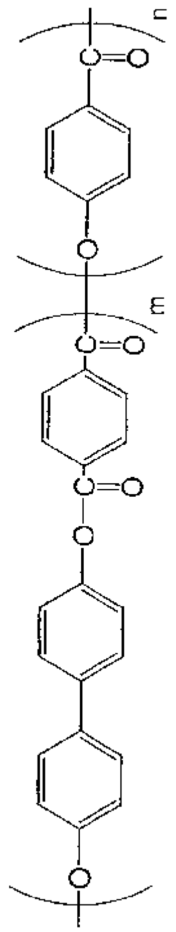

(2)

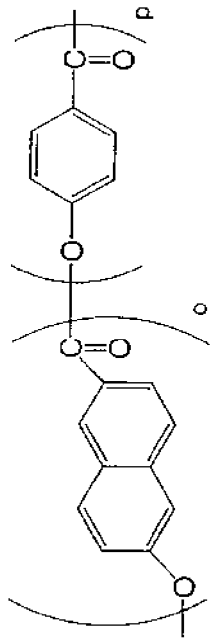

(3)

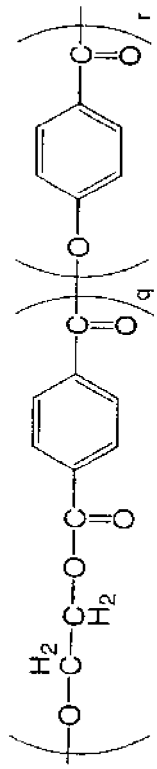

The wholly aromatic liquid crystal polyester film is commercially available, for example, as trade name "BIAC" from Japan Gore-Tex Inc.

Examples of the cycloolefin resins include thermoplastic norbornene-based resins. These thermoplastic norbornene-based resins are disclosed in Japanese Patent Laid-Open No. S51-80400, Japanese Patent Laid-Open No. S60-26024, Japanese Patent Laid-Open No. H01-168725, Japanese Patent Laid-Open No. H01-190726, Japanese Patent Laid-Open No. H03-14882, Japanese Patent Laid-Open No. H03-122137, Japanese Patent Laid-Open No. H04-63807, and the like.

Specifically, the thermoplastic norbornene-based resins include a ring-opening polymer of a norbornene-based monomer, a ring-opening polymer hydrogen additive of a norbornene-based monomer, an addition polymer of a norbornene-based monomer, and an addition copolymer of a norbornene-based monomer and an olefin.

Examples of the norbornene-based monomer include 2-norbornene, 5-methyl-2-norbornene, 5,5-dimethyl-2-norbornene, 5-ethyl-2-norbornene, 5-butyl-2-norbornene, 5-hexyl-2-norbornene, 5-octyl-2-norbornene, 5-octadecyl-2-norbornene, 5-ethylidene-2-norbornene, 5-isopropenyl-2-norbornene, 5-methoxycarbonyl-2-norbornene, 5-cyano-2-norbornene, 5-methyl-5-methoxycarbonyl-2-norbornene, 5-phenyl-2-norbornene, and 5-phenyl-5-methyl-norbornene.

The norbornene-based monomer may be a monomer with addition of one or more cyclopentadienes to norbornene or a derivative or a substitute thereof, may be a monomer with a polycyclic structure that is a multimer of a cyclopentadiene, or a derivative or a substitute thereof, and may be a cyclopentadiene with tetrahydroindene, indene, benzofuran, or the like, an adduct thereof, or a derivative or a substitute thereof.

The thermoplastic norbornene-based resin is obtained by polymerizing a monomer containing at least 1 of the above-described norbornene-based monomers, and other than the above-described norbornene-based monomers, a monomer copolymerizable with a norbornene-based monomer may be copolymerized. The monomer copolymerizable with a norbornene-based monomer includes cycloolefins such as cyclopentene, cyclohexene, cycloheptene, and cyclooctene.

When the thermoplastic norbornene-based resin is an addition copolymer of a norbornene-based monomer and an olefin, an $\alpha$-olefin such as ethylene, propylene, 1-butene, 1-hexene, or 4-methyl-1-pentene is used as the olefin.

The thermoplastic norbornene-based resin may contain additives such as an antioxidant such as a phenol-based or phosphorus-based antioxidant, an ultraviolet absorber such as a benzophenone-based ultraviolet absorber, a light-resistant stabilizer, an antistatic agent, and a lubricant such as an ester of an aliphatic alcohol, or a partial ester or a partial ether of a polyhydric alcohol, as necessary.

When the melting point or glass-transition temperature of a polymer composing the composite base material 1 is low, heat resistance of the underside protective sheet for solar cell may be degraded, and dimensional stability may be degraded. Therefore, the melting point is preferably 120°C or more, and more preferably 125 to 300°C. Incidentally, the melting point or glass-transition temperature of a polymer refers to those measured in accordance with JIS K0064.

When the moisture vapor transmission rate of a polymer measured in accordance with JIS K7126 at 23°C with a relative humidity of 90% at a thickness of 100 $\mu$m is high, gas barrier properties of the underside protective sheet for solar cell are degraded. Therefore, the moisture vapor transmission rate is limited to 10 g/m$^2$·day or less, and preferably 3 g/m$^2$·day or less. Incidentally, the moisture vapor transmission rate of a polymer at 23°C at a thickness of 100 $\mu$m refers to those measured in accordance with JIS K7126 at 23°C with a relative humidity of 90%.

The composite base material contains plate-like inorganic particles dispersed in the polymer. Examples of the plate-like inorganic particles include synthetic mica, alumina, and boehmite.

The plate-like inorganic particles may be an inorganic layered compound formed in laminate by laminating plural layers in the thickness direction. Examples of the inorganic layered compound include clay minerals such as kaolinite group, smectite group, and mica group. Examples of the inorganic layered compound of the smectite group include montmorillonite, hectorite, and saponite, and montmorillonite is preferable.

When the average size of the plate-like inorganic particles is too large, the appearance of the base material may be degraded. Therefore, the average size is preferably 10 nm to 500 $\mu$m. When the aspect ratio of the plate-like inorganic particles is small, gas barrier properties of the underside protective sheet for solar cell may be degraded. Therefore, the larger the aspect ratio, the better the gas barrier properties will be, and the aspect ratio is preferably 3 or more. The average size of the plate-like inorganic particles refers to the arithmetic average value of the sum of the maximum length and the minimum length of the plate-like inorganic particles confirmed by observation by a TEM method.

Incidentally, the average size of the plate-like inorganic particles can be determined by a TEM method, and the aspect ratio is defined as described below.

Aspect Ratio = Average Length of Crystal Surface/Maximum Thickness of Plate-like Inorganic Particles

However, the average length of crystal surface is defined as the arithmetic average value of the maximum length of each plate-like inorganic particle upon TEM observation, and the maximum thickness of the plate-like inorganic particles is defined as the arithmetic average value of the thickness of each plate-like inorganic particle upon TEM observation.

When the content of the plate-like inorganic particles in the composite base material is 3 parts by weight or more based on 100 parts by weight of the polymer, gas barrier properties of the base material itself can be effectively improved, and also the effect of filling a defect such as a pinhole of the vapor-deposited layer can be enhanced. However, when the plate-like inorganic particles are excessively contained, the base material may become fragile and cannot maintain necessary strength, or film forming may become difficult. Therefore, it is preferable that the plate-like inorganic particles are contained in an amount of 5 to 80 parts by weight based on 100 parts by weight of the polymer.

When the thickness of the composite base material is thin, barrier properties of the whole underside protective sheet for solar cell to oxygen and moisture vapor may be degraded. Therefore, the thickness is preferably 20 $\mu$m or more. The upper limit is not particularly limited, but it is preferably 400 $\mu$m considering handling properties and the like.

The sol-gel layer 2 is laminated and integrated on the composite base material 1. This sol-gel layer 2 is formed by hardening one or more compounds selected from the group consisting of a compound (A), a compound (B) and a compound (C):

(A) a silicon compound represented by $R^1_nSi(OX)_{4-n}$ or a hydrolysate thereof
(B) an organometal compound represented by $M(OX)_m$ or a hydrolysate thereof
(C) an alkali metal polysilicate

wherein X independently represents an alkyl group having 1 to 6 carbon atoms or an acyl group having 1 to 6 carbon atoms, $R^1$ independently represents an alkyl group having 1 to 12 carbon atoms or a nonhydrolyzable functional group having polymerizability, M represents a metal atom, n represents 0 or an integer of 1 to 3, and m represents an integer of 2 to 4.

(A) The silicon compound represented by $R^1_nSi(OX)_{4-n}$ or the hydrolysate thereof will be explained.

In $R^1_nSi(OX)_{4-n}$, X independently represents an alkyl group having 1 to 6 carbon atoms or an acyl group having

1 to 6 carbon atoms. $R^1$ independently represents an alkyl group having 1 to 12 carbon atoms or a nonhydrolyzable functional group having polymerizability. n represents 0 or an integer of 1 to 3.

Examples of X include a methyl group, an ethyl group, a propyl group, a butyl group, and an acetoxy group. Examples of $R^1$ include a methyl group, an ethyl group, a propyl group, a butyl group, a vinyl group, a glycidoxy group, a glycidoxy group, a glycidoxyethyl group, a glycidoxymethyl group, a glycidoxypropyl group, and a glycidoxybutyl group. $R^1$ is an organic segment, and regardless of whether $R^1$ is unreacted, addition reaction, or a condensation reaction, it provides flexibility to the sol-gel layer.

Examples of the silicon compound represented by $R^1{}_nSi(OX)_{4-n}$ include tetraalkoxysilanes such as methyl silicate, ethyl silicate, n-propyl silicate, i-propyl silicate, n-butyl silicate, sec-butyl silicate and t-butyl silicate, trialkoxysilanes such as methyltrimethoxysilane, methyltriethoxysilane, methyltrimethoxyethoxysilane, methyltriacetoxysilane, methyltributoxysilane, ethyltrimethoxysilane, ethyltriethoxysilane, vinyltrimethoxysilane, vinyltriethoxysilane, vinyltriacetoxysilane, vinyltrimethoxyethoxysilane, γ-chloropropyltrimethoxysilane, γ-chloropropyltriethoxysilane, γ-chloropropyltriacetoxysilane, 3,3,3-trifluoropropyltrimethoxysilane, γ-methacryloxypropyltrimethoxysilane, γ-aminopropyltrimethoxysilane, γ-aminopropyltriethoxysilane, γ-mercaptopropyltrimethoxysilane, γ-mercaptopropyltriethoxysilane, N-β-(aminoethyl)-γ-aminopropyltrimethoxysilane, β-cyanoethyltriethoxysilane, chloromethyltrimethoxysilane, chloromethyltriethoxysilane, glycidoxymethyltrimethoxysilane, glycidoxymethyltriethoxysilane, α-glycidoxyethyltrimethoxysilane, α-glycidoxyethyltriethoxysilane, β-glycidoxyethyltriethoxysilane, α-glycidoxypropyltrimethoxysilane, α-glycidoxypropyltriethoxysilane, β-glycidoxypropyltrimethoxysilane, β-glycidoxypropyltriethoxysilane, γ-glycidoxypropyltrimethoxysilane, γ-glycidoxypropyltriethoxysilane, γ-glycidoxypropyltripropoxysilane, γ-glycidoxypropyltributoxysilane, γ-glycidoxypropyltrimethoxyethoxysilane, α-glycidoxybutyltrimethoxysilane, α-glycidoxybutyltriethoxysilane, β-glycidoxybutyltrimethoxysilane, β-glycidoxybutyltriethoxysilane, γ-glycidoxybutyltrimethoxysilane, γ-glycidoxybutyltriethoxysilane, δ-glycidoxybutyltrimethoxysilane, δ-glycidoxybutyltriethoxysilane, (3,4-epoxycyclohexyl)methyltrimethoxysilane, (3,4-epoxycyclohexyl)methyltriethoxysilane, β-(3,4-epoxycyclohexyl)ethyltrimethoxysilane, β-(3,4-epoxycyclohexyl)ethyltriethoxysilane, β-(3,4-epoxycyclohexyl)ethyltripropoxysilane, β-(3,4-epoxycyclohexyl)ethyltributhoxysilane, β-(3,4-epoxycyclohexyl)ethyltrimethoxyethoxysilane, γ-(3,4-epoxycyclohexyl)propyltriethoxysilane, δ-(3,4-epoxycyclohexyl)butyltrimethoxysilane, and δ-(3,4-epoxycyclohexyl)butyltriethoxysilane, triacyloxysilanes, dimethyldimethoxysilane, dimethyldiethoxysilane, γ-chloropropylmethyldimethoxysilane, γ-chloropropylmethyldiethoxysilane, dimethyldiacetoxysilane, γ-methacyrloxypropylmethyldimethoxysilane, γ-methacyrloxypropylmethyldiethoxysilane, γ-mercaptopropylmethyldimethoxysilane, γ-mercaptopropylmethyldiethoxysilane, γ-aminopropylmethyldimethoxysilane, γ-aminopropylmethyldiethoxysilane, methylvinyldimethoxysilane, methylvinyldiethoxysilane, glycidoxymethylmethyldimethoxysilane, glycidoxymethylmethyldiethoxysilane, α-glycidoxyethylmethyldimethoxysilane, α-glycidoxyethylmethyldiethoxysilane, β-glycidoxyethylmethyldimethoxysilane, β-glycidoxyethylmethyldiethoxysilane, α-glycidoxypropylmethyldimethoxysilane, α-glycidoxypropylmethyldiethoxysilane, β-glycidoxypropylmethyldimethoxysilane, β-glycidoxypropylmethyldiethoxysilane, γ-glycidoxypropylmethyldimethoxysilane, γ-glycidoxypropylmethyldiethoxysilane, γ-glycidoxypropylmethyldipropoxysilane, γ-glycidoxypropylmethyldibutoxysilane, γ-glycidoxypropylmethyldimethoxyethoxysilane, γ-glycidoxypropylethyldimethoxysilane, γ-glycidoxypropylethyldiethoxysilane, γ-glycidoxypropylethyldipropoxysilane, and γ-glycidoxypropylvinyldiethoxysilane. Incidentally, the silicon compound may be used alone or may be used in combination of 2 or more kinds. As the silicon compound, ethyl silicate and γ-glycidoxypropyltrimethoxyethoxysilane are preferably used in combination.

The hydrolysate of the silicon compound represented by $R^1{}_nSi(OX)_{4-n}$ can be obtained by mixing $R^1{}_nSi(OX)_{4-n}$, an organic solvent, and an acid aqueous solution, to hydrolyze $R^1{}_nSi(OX)_{4-n}$.

The organic solvent is not particularly limited as long as it is compatible with the silicon compound represented by $R^1{}_nSi(OX)_{4-n}$ and the acid aqueous solution. Examples include methyl alcohol, ethyl alcohol, isopropyl alcohol, ethoxyethyl alcohol, and allyl alcohol, and isopropyl alcohol is preferable.

The acid aqueous solution refers to an aqueous solution having a pH of 1 to 6, obtained by dissolving acidic species in distilled water. Examples of the acidic species include hydrochloric acid, nitric acid, sulfuric acid, and acetic acid, and nitric acid is preferable since adjustment of pH is easy.

(B) The organometal compound represented by $M(OX)_m$ or the hydrolysate thereof will be explained. m represents an integer of 2 to 4. Here, X independently represents an alkyl group having 1 to 6 carbon atoms or an acyl group having 1 to 6 carbon atoms. Since X is the same as described above, the explanation is omitted.

In the organometal compound represented by $M(OX)_m$, examples of a metal atom M include Ti, Al, and Zr.

Examples of the organometal compound represented by $M(OX)_m$ include tetramethoxytitanium, tetraethoxytitanium, tetraisopropoxytitanium, tetrabutoxytitanium, trimethoxyaluminum, triethoxyaluminum, triisopropoxyaluminum, tributoxyaluminum, tetramethoxyzirconium, tetraethoxyzirconium, tetraisopropoxyzirconium, and tetrabutoxyzirconium. Incidentally, the organometal compound represented by $M(OX)_m$ may be used alone or may be used in combination of 2 or more kinds.

The hydrolysate of the organometal compound represented by $M(OX)_m$ can be obtained by mixing $M(OX)_m$, an organic solvent, and an acid aqueous solution, to hydrolyze $M(OX)_m$.

The organic solvent may be used as long as it is compatible with the organometal compound represented by $M(OX)_m$ and the acid aqueous solution. Examples include methyl alcohol, ethyl alcohol, isopropyl alcohol, ethoxyethyl alcohol, and allyl alcohol, and isopropyl alcohol is preferable.

Since the acid aqueous solution is the same as the acid aqueous solution used when $R^1{}_nSi(OX)_{4-n}$ is hydrolyzed, the explanation is omitted.

Examples of (C) the alkali metal polysilicate include lithium polysilicate ($Li_2O{\cdot}qSiO_2$), sodium polysilicate ($Na_2O{\cdot}qSiO_2$), and potassium polysilicate ($K_2O{\cdot}qSiO_2$), and lithium polysilicate ($Li_2O{\cdot}qSiO_2$) is preferable. Herein, q is the molar ratio. Incidentally, the alkali metal polysilicate may be used alone or may be used in combination of 2 or more kinds, and it is preferred that lithium polysilicate is contained from the viewpoint of barrier properties.

Furthermore, plate-like inorganic particles may be contained in the sol-gel layer 2. The plate-like inorganic particles are contained in the sol-gel layer 2, thereby blocking pinhole, crack, and the like formed on the sol-gel layer 2, and barrier properties of the sol-gel layer to oxygen and moisture vapor can be improved. Incidentally, since the plate-like inorganic particles are the same as the plate-like inorganic particles contained in the composite base material, the explanation is omitted.

When the content of the plate-like inorganic particles in the sol-gel layer 2 is small, barrier properties to oxygen and moisture vapor of the sol-gel layer may be degraded, and when the content is large, film-forming properties may be degraded. Therefore, the content is preferably 5 to 300 parts by weight, and more preferably 20 to 200 parts by weight based on 100 parts by weight of the total weight of one or more compounds selected from (A) to (C).

When the thickness of the sol-gel layer 2 is thin, barrier properties of the underside protective sheet for solar cell to oxygen and moisture vapor may be degraded, and when the thickness is thick, crack may be generated in the sol-gel layer due to the difference in the contraction ratios with the composite base material upon forming the sol-gel layer, or crack may be generated upon handling due to lack of flexibility of the sol-gel layer itself, and consequently, barrier properties of the underside protective sheet for solar cell may be rather degraded. Therefore, the thickness is preferably 0.1 to 50 $\mu$m.

It is preferred that the vapor-deposited film 3 and the base material film 4 are laminated and integrated in this order or the inverse order on the sol-gel layer 2. More specifically, it is preferred that the vapor-deposited film 3 is laminated and integrated on the sol-gel layer 2, and the base material film 4 is laminated and integrated on the vapor-deposited film 3. Alternatively, it is preferred that the base material film 4 is laminated and integrated on the sol-gel layer 2, and the vapor-deposited film 3 is laminated and integrated on the base material film 4. As shown in Fig. 2, it is more preferred that the vapor-deposited film 3 is laminated and integrated on the sol-gel layer 2, and the base material film 4 is laminated and integrated on the vapor-deposited film 3. The vapor-deposited film 3 is normally formed on the surface of the base material film 4, and then the vapor-deposited film 3 and the base material film 4 are laminated and integrated on the sol-gel layer 2.

The synthetic resin composing the base material film 4 is not particularly limited as long as a vapor-deposited film can be formed on the surface, and examples include biodegradable plastics such as polylactic acid, polyolefin-based resins such as a polyethylene and a polypropylene, polyester-based resins such as polyethylene terephthalate, polybutylene terephthalate, and polyethylene naphthalate, polyamide-based resins such as nylon-6 and nylon-66, polyvinyl chloride, polyimides, polystylenes, polycarbonates, and polyacrylonitrile. Here, the base material film 4 may be either a stretched film or an unstretched film, and those excellent in mechanical strength, dimensional stability, and heat resistance are preferable.

The base material film 4 may contain known additives such as an antistatic agent, an ultraviolet absorber, a plasticizer, a lubricant, and a colorant, as necessary.

The surface of the base material film 4 may be subjected to surface modification such as a corona treatment, an ozone treatment, or a plasma treatment, to improve adherence to the vapor-deposited film. The thickness of the base material film 4 is preferably 3 to 200 $\mu$m and more preferably 10 to 200 $\mu$m.

In addition, examples of the materials composing the vapor-deposited film 3 include silicon oxide, silicon nitride, silicon oxynitride, silicon carbide nitride, aluminum oxide, calcium oxide, magnesium oxide, zirconium oxide, titanium oxide, and titanium nitride, and silicon oxide and aluminum oxide are preferable, and silicon oxide is more preferable since adherence to the sol-gel layer is good.

The vapor-deposited film made of silicon oxide may contain metals such as aluminum, magnesium, calcium, potassium, sodium, titanium, zirconium, and yttrium, and nonmetal atoms such as carbon, boron, nitrogen, and fluorine, in addition to silicon and oxygen which are the main constituents.

The vapor-deposited film 3 may be a single layer, or a film obtained by laminating and integrating plural layers for improving barrier properties. When the vapor-deposited film 3 is a film obtained by laminating and integrating plural layers, the material composing each layer may be of the same or different kind(s).

When the thickness of the vapor-deposited film 3 is thin, barrier properties of the underside protective sheet for solar cell to oxygen and moisture vapor may be degraded, and when the thickness is thick, crack or the like is likely to occur due to the difference in the contraction ratios with the base material film upon forming the vapor-deposited film

3, and barrier properties of the underside protective sheet for solar cell may be rather degraded. Therefore, the thickness is preferably 5 nm to 5000 nm, more preferably 50 nm to 1000 nm, and particularly preferably 100 nm to 500 nm. When the vapor-deposited film 3 is formed from aluminum oxide or silicon oxide, the thickness of the vapor-deposited film 3 is preferably 10 nm to 300 nm.

Examples of the method of forming the vapor-deposited film 3 on the surface of the base material film 4 include physical vapor deposition (PVD) methods such as a sputtering method, a vapor-deposition method, and an ion plating method, and chemical vapor deposition (CVD) methods, and chemical vapor deposition (CVD) methods are preferable since the influence of heat on the base material film can be relatively suppressed, and further a uniform vapor-deposited film can be formed with good production efficiency.

As shown in Fig. 3, in order to improve the weatherability of the underside protective sheet for solar cell, the underside protective sheet for solar cell may have a polyvinyl fluoride film layer 5 or a fluorine-based coating layer 5 as the outermost layer. More specifically, the polyvinyl fluoride film layer 5 or the fluorine-based coating layer 5 may be laminated and integrated on the composite base material 1 of the underside protective sheet for solar cell. The polyvinyl fluoride film layer 5 or the fluorine-based coating layer 5 may be laminated and integrated on the base material film 4 or the vapor-deposited film 3 of the underside protective sheet for solar cell. It is preferred that the polyvinyl fluoride film layer 5 or the fluorine-based coating layer 5 is laminated and integrated on the base material film 4 of the underside protective sheet for solar cell. Fig. 3 shows the case where the polyvinyl fluoride film layer 5 or the fluorine-based coating layer 5 is laminated and integrated on the base material film 4. Here, the thickness of the polyvinyl fluoride film layer 5 or the fluorine-based coating layer 5 is preferably 1 to 50 $\mu$m.

Furthermore, as shown in Fig. 4, in order to improve the weatherability of the underside protective sheet for solar cell, the underside protective sheet for solar cell may have a polyvinyl fluoride film layer 5 or a fluorine-based coating layer 5 as the outermost layer. More specifically, the polyvinyl fluoride film layer 5 or the fluorine-based coating layer 5 may be laminated and integrated on the composite base material 1 of the underside protective sheet for solar cell. The polyvinyl fluoride film layer 5 or the fluorine-based coating layer 5 may be laminated and integrated on the sol-gel layer 2 of the underside protective sheet for solar cell. Fig. 4 shows the case where the polyvinyl fluoride film layer 5 or the fluorine-based coating layer 5 is laminated and integrated on the sol-gel layer 2. Here, the thickness of the polyvinyl fluoride film layer 5 or the fluorine-based coating layer 5 is preferably 1 to 50 $\mu$m.

Examples of the fluorine-based coating layer include a polyvinyl fluoride (PVF) layer, a polytetrafluoroethylene (PTFE) layer, and an ethylene-tetrafluoroethylene copolymer (ETFE) layer.

Next, one example of a method of manufacturing the underside protective sheet for solar cell will be described. First, as a method of producing the composite base material 1, for example, a composite base material can be obtained by feeding a polymer and plate-like inorganic particles into an extruder, melt-kneading the mixture, and extruding the mixture into a film form. Subsequently, a sol solution containing one or more selected from (A) to (C) described above and plate-like inorganic particles as necessary is prepared, and the sol solution is applied to the composite base material 1 at a predetermined thickness, to form a sol layer. This sol layer is dehydrated and polycondensed while being dried with heat, to form a sol-gel layer, whereby an underside protective sheet for solar cell can be manufactured.

When the vapor-deposited film 3 and the base material film 4 are laminated and integrated on the sol-gel layer 2, the base material film 4 on which surface the vapor-deposited film 3 is formed is prepared in the manner described above. This vapor-deposited film 3 or the base material film 4 may be laminated and integrated on the sol-gel layer. The lamination and integration method includes a method of interposing an adhesive or an adhesive resin. As the adhesive, an adhesive capable of dry lamination is preferably selected. Melt extrusion lamination that interposes an adhesive resin may also be adopted. As these adhesives and adhesive resins, appropriate one may be selected according to the material of the adhesive surface. Incidentally, the formation of the sol-gel layer is not necessarily performed on the composite base material 1 and can be performed on either surface of the base material film 4 on which the vapor-deposited film 3 is formed.

Here, examples of the method for applying a sol solution include dipping, roll coating, gravure coating, reverse coating, air knife coating, comma coating, die coating, screen printing, spray coating, gravure offset, and bar coating. Examples of the method for drying a sol solution with heat include a method of blasting hot air, a method of passing the sol solution between heat rollers, and a method of irradiating the sol solution with inflared light.

Furthermore, when the underside protective sheet for solar cell A has the polyvinyl fluoride film layer 5 or the fluorine-based coating layer 5 as the outermost layer, a polyvinyl fluoride film may be laminated and integrated or a fluorine-based paint may be applied and dried in a generalized manner on the underside protective sheet for solar cell A manufactured in the manner described above.

Next, the underside protective sheet for solar cell A of the present invention is used for manufacturing a solar cell module. As shown in Fig. 5, a solar cell element 6 formed from silicon or the like is sealed by being vertically sandwiched with sealing materials 7 and 8 such as an ethylene-vinyl acetate copolymer film, a glass plate 9 is laminated and integrated on the sealing material 7 on the front side as a transparent protective member, and also the underside protective sheet for solar cell A is laminated and integrated on the sealing material 8 on the back side as a backsheet,

thereby composing a solar cell module B.

Incidentally, when the vapor-deposited film 3 or the base material film 4 is laminated and integrated on the underside protective sheet for solar cell A, it is desired that the vapor-deposited film 3 or the base material film 4 is laminated adjacent to the side of the solar cell element 6. When the polyvinyl fluoride film layer 5 or the fluorine-based coating layer 5 is formed on the sol-gel layer 2, the polyvinyl fluoride film layer 5 or the fluorine-based coating layer 5 is laminated so as to be the outermost layer, whereby excellent weatherability can be provided to the underside protective sheet for solar cell A.

When the solar cell element 6 of the solar cell module B is exposed to oxygen or moisture vapor, it may cause oxidation degradation such as rust and degrade power generation capacity. Therefore, while the front and back sides of the solar cell element 6 are sealed with the sealing materials 7 and 8, barrier properties of the sealing materials 7 and 8 to oxygen and moisture vapor are not so enough.

The glass plate 9 is laminated and integrated on the front (light-receiving surface) side of the solar cell element 6 as a protective layer, and since the glass plate 9 is excellent in barrier properties to oxygen and moisture vapor, the glass plate 9 compensates deficit in barrier properties of the sealing material 7.

On the other hand, the underside protective sheet for solar cell A of the present invention is laminated and integrated on the sealing material 8 of the back side of the solar cell element 6, thereby preventing oxidation degradation of the solar cell element 6 due to ingress of oxygen and moisture vapor from the back side of the solar cell 6 by excellent barrier properties of the underside protective sheet for solar cell A to oxygen and moisture vapor, and power generation performance of the solar cell element 6 can be well maintained over a long period.

In the above description, the case where the underside protective sheet for solar cell A is laminated and integrated on the sealing material 8 that seals the back side of the solar cell element 4 is described. As shown in Figs. 6 and 7, it is preferred that an ethylene-vinyl acetate copolymer film layer 10 is preliminarily laminated and integrated on the underside protective sheet for solar cell A. When the underside protective sheet for solar cell A has the vapor-deposited film 3 and the base material film 4, it is preferred that the ethylene-vinyl acetate copolymer film layer 10 is preliminarily laminated and integrated on the side of the vapor-deposited film 3 or the base material film 4 of the underside protective sheet for solar cell A as the outermost layer. By employing the constitution as described above, the sealing material 8 and the underside protective sheet for solar cell A can be treated as one member, not as separate members, and promotion of work efficiency is possible. Here, it is necessary that the ethylene-vinyl acetate copolymer film layer 10 is laminated and integrated opposite to the solar cell element 6.

As shown in Figs. 6 and 7, when the polyvinyl fluoride film layer 5 or the fluorine-based coating layer 5 is laminated and integrated on the underside protective sheet for solar cell A, it is necessary that the ethylene-vinyl acetate copolymer film layer 10 is formed on the side on which the polyvinyl fluoride film layer 5 or the fluorine-based coating layer 5 is not laminated.

Furthermore, as shown in Figs. 8 and 9, a sealing layer 11 may be laminated and integrated on either side of the underside protective sheet for solar cell A. In Fig. 8, it is preferred that the sealing layer 11 is laminated and integrated on the sol-gel layer 2 of the underside protective sheet for solar cell A. As in Fig. 9, when the underside protective sheet for solar cell A has the vapor-deposited film 3 and the base material film 4, it is preferred that the sealing layer 11 is laminated and integrated on the vapor-deposited film 3 or the base material film 4. It is more preferred that the sealing layer 11 is laminated and integrated on the base material film 4 of the underside protective sheet for solar cell A. Here, when the underside protective sheet for solar cell A has the polyvinyl fluoride film layer 5 or the fluorine-based coating layer 5, the sealing layer 11 is laminated and integrated on the side on which the polyvinyl fluoride film layer 5 or the fluorine-based coating layer 5 is not laminated. More specifically, the sealing layer 11 is laminated and integrated on one side (first side) of the underside protective sheet for solar cell A, and the polyvinyl fluoride film layer 5 or the fluorine-based coating layer 5 is laminated and integrated on the other side (second side) of the underside protective sheet for solar cell A.

Specifically, the sealing layer 11 preferably contains a modified polyolefin-based resin and a silane compound represented by $R^2Si(OR^3)_3$, more preferably contains 100 parts by weight of a modified polyolefin-based resin graft-modified with an unsaturated carboxylic acid or an anhydride thereof and having a melting point measured in accordance with JIS K7121 of 120 to 170°C and 0.001 to 20 parts by weight of a silane compound represented by $R^2Si(OR^3)_3$, and particularly preferably contains 100 parts by weight of a modified polypropylene-based resin graft-modified with an unsaturated carboxylic acid or an anhydride thereof and having a melting point measured in accordance with JIS K7121 of 120 to 170°C and 0.001 to 20 parts by weight of a silane compound represented by $R^2Si(OR^3)_3$. Fig. 9 shows the case where the sealing layer 11 is laminated and integrated on the vapor-deposited film 3 or the base material film 4. $R^2$ represents a nonhydrolyzable functional group having polymerizability. $R^3$ represents an alkyl group having 1 to 5 carbon atoms. The sealing layer 11 is excellent in barrier properties to oxygen and moisture vapor as compared to a sealing material such as an ethylene-vinyl acetate copolymer film and is laminated and integrated on the underside protective sheet for solar cell A, to exhibit excellent gas barrier properties.

Examples of the modified polyolefin-based resin composing the sealing layer 11 include a polyolefin resin graft-modified with an unsaturated carboxylic acid or an anhydride thereof, a copolymer of ethylene or/and propylene and acrylic acid or methacrylic acid, and a metal-crosslinked polyolefin resin, and a polypropylene-based resin graft-modified with an unsaturated carboxylic acid or an anhydride thereof is preferable. In addition, a butene component, an ethylene-propylene-butene copolymer, a noncrystalline ethylene-propylene copolymer, a propylene-α-olefin copolymer, or the like may be added to the modified polyolefin-based resin in an amount of 5% by weight or more, as necessary.

The above-described polyolefin-based resin is not particularly limited, and examples include polyethylene-based resins and polypropylene-based resins. Examples of the above-described polyethylene-based resin include a polyethylene, and a copolymer of an ethylene and other monomers such as α-olefin that contains 50% by weight or more of an ethylene component. Here, examples of the α-olefin include propylene, 1-butene, isobutene, 1-pentene, 3-methyl-1-butene, 1-hexene, 4-methyl-1-pentene, neohexene, 1-heptene, 1-octene, and 1-decene.

Examples of the above-described polypropylene-based resin include polypropylene, and a copolymer of a propylene and other monomers such as α-olefin that contains 50% by weight of a propylene component, and an ethylene-propylene random copolymer and a propylene-butene-ethylene terpolymer are preferable. Here, examples of the α-olefin include ethylene, 1-butene, isobutene, 1-pentene, 3-methyl-1-butene, 1-hexene, 4-methyl-1-pentene, neohexene, 1-heptene, 1-octene, and 1-decene.

When the content of an ethylene component in the ethylene-propylene random copolymer is small, adhesion of the sealing layer may be degraded, and when the content is large, the underside protective sheet for solar cell may cause the blocking. Therefore, the content is preferably 1 to 10% by weight, and more preferably 1.5 to 5% by weight.

Examples of the unsaturated carboxylic acid include maleic acid, acrylic acid, methacrylic acid, itaconic acid, fumaric acid, and citraconic acid, and maleic acid is preferable. Examples of the anhydride of the unsaturated carboxylic acid include maleic anhydride, citraconic anhydride, and itaconic anhydride, and maleic anhydride is preferable.

Examples of the method of modifying a polyolefin-based resin with an unsaturated carboxylic acid or an anhydride of the unsaturated carboxylic acid include a method of heat-treating a crystalline polypropylene and an unsaturated carboxylic acid or an anhydride of the unsaturated carboxylic acid to the melting point of the crystalline polypropylene in the presence of an organic peroxide in a solvent or in the absence of a solvent, and copolymerization of an unsaturated carboxylic acid or an anhydride of the unsaturated carboxylic acid upon polymerizing polyolefin-based resins.

When the total content of an unsaturated carboxylic acid or an anhydride of the unsaturated carboxylic acid in the modified polyolefin-based resin (hereinafter referred to as "modified rate") is small, adhesion of the sealing layer may be degraded, and when the total content is large, the underside protective sheet for solar cell may cause the blocking. Therefore, the total content is preferably 0.01 to 20% by weight and more preferably 0.05 to 10% by weight.

When the melting point measured in accordance with JIS K7121 of the modified polyolefin-based resin composing the sealing layer 11 is low, film-forming properties are degraded, and when the melting point is high, adhesion of the sealing layer is degraded. Therefore, the melting point is preferably 120 to 170°C, and more preferably 120 to 145°C.

Furthermore, the sealing layer 11 contains a silane compound represented by $R^2Si(OR^3)_3$ in order to ensure long-term adhesion to a transparent substrate composing a solar cell. $R^2$ represents a nonhydrolyzable functional group having polymerizability. $R^3$ represents an alkyl group having 1 to 5 carbon atoms.

Examples of $R^2$ include a vinyl group, a glycidoxy group, a glycidoxyethyl group, a glycidoxymethyl group, a glycidoxypropyl group, and a glycidoxybutyl group. Examples of $R^3$ include a methyl group, an ethyl group, a propyl group, a butyl group, and a pentyl group.

Examples of the silane compound represented by $R^2Si(OR^3)_3$ include vinyltrimethoxysilane, vinyltriethoxysilane, vinyltriacetoxysilane, vinyltrimethoxyethoxysilane, γ-methacryloxypropyltrimethoxysilane, glycidoxymethyltrimethoxysilane, glycidoxymethyltriethoxysilane, α-glycidoxyethyltrimethoxysilane, α-glycidoxyethyltriethoxysilane, β-glycidoxyethyltriethoxysilane, α-glycidoxypropyltrimethoxysilane, α-glycidoxypropyltriethoxysilane, β-glycidoxypropyltrimethoxysilane, β-glycidoxypropyltriethoxysilane, γ-glycidoxypropyltrimethoxysilane, γ-glycidoxypropyltriethoxysilane, γ-glycidoxypropyltripropoxysilane, γ-glycidoxypropyltributoxysilane, γ-glycidoxypropyltrimethoxyethoxysilane, α-glycidoxybutyltrimethoxysilane, α-glycidoxybutyltriethoxysilane, β-glycidoxybutyltrimethoxysilane, β-glycidoxybutyltriethoxysilane, γ-glycidoxybutyltrimethoxysilane, γ-glycidoxybutyltriethoxysilane, δ-glycidoxybutyltrimethoxysilane, δ-glycidoxybutyltriethoxysilane, (3,4-epoxycyclohexyl)methyltrimethoxysilane, (3,4-epoxycyclohexyl)methyltriethoxysilane, β-(3,4-epoxycyclohexyl)ethyltrimethoxysilane, β-(3,4-epoxycyclohexyl)ethyltriethoxysilane, β-(3,4-epoxycyclohexyl)ethyltripropoxysilane, β-(3,4-epoxycyclohexyl)ethyltributhoxysilane, β-(3,4-epoxycyclohexyl)ethyltrimethoxyethoxysilane, γ-(3,4-epoxycyclohexyl)propyltriethoxysilane, δ-(3,4-epoxycyclohexyl)butyltrimethoxysilane, and δ-(3,4-epoxycyclohexyl)butyltriethoxysilane. Incidentally, these silane compounds may be used alone or may be used in combination of 2 or more kinds.

When the content of the silane compound in the sealing layer 11 is small, the effect of adding the silane compound may not be exhibited, and when the content is large, film-forming properties may be degraded. Therefore, the content is preferably 0.001 to 20 parts by weight, and more preferably 0.005 to 10 parts by weight based on 100 parts by weight of the modified polypropylene-based resin.

The sealing layer 11 may contain additives such as a light stabilizer, an ultraviolet absorber, and a heat stabilizer,

to such a degree that the properties are not impaired.

Furthermore, since hot pressing or the like is performed for a certain period of time upon preparation of a solar cell module, the underside protective sheet for solar cell may cause thermal contraction and have problems such as generation of creases on the underside protective sheet for solar cell due to thermal contraction. Therefore, as shown in Figs. 10 and 11, a thermal buffer layer 12 may be interposed between the underside protective sheet for solar cell A and the sealing layer 11 for protecting the underside protective sheet for solar cell A from heat. The thermal buffer layer 12 is made of a polyolefin-based resin having a melting point of 160°C or more and a flexural modulus of 500 to 1500 MPa. Incidentally, Fig. 10 shows the case where the thermal buffer layer 12 and the sealing layer 11 are laminated and integrated in this order on the vapor-deposited film 3 or the base material film 4.

Examples of the polyolefin-based resin composing the thermal buffer layer 12 include a polyethylene-based resin and a polypropylene-based resin.

Examples of the polyethylene-based resin include a polyethylene, and a copolymer of an ethylene and other monomers such as an α-olefin that contains 50% by weight or more of an ethylene component. Here, examples of the α-olefin include propylene, 1-butene, isobutene, 1-pentene, 3-methyl-1-butene, 1-hexene, 4-methyl-1-pentene, neohexene, 1-heptene, 1-octene, and 1-decene.

Examples of the polypropylene-based resin include a homopolypropylene, and a copolymer of a propylene and other monomers such as an α-olefin that contains 50% by weight of a propylene component. Here, examples of the α-olefin include ethylene, 1-butene, isobutene, 1-pentene, 3-methyl-1-butene, 1-hexene, 4-methyl-1-pentene, neohexene, 1-heptene, 1-octene, and 1-decene.

When the melting point measured in accordance with JIS K7121 in the polyolefin-based resin composing the thermal buffer layer 12 is low, the underside protective sheet for solar cell possibly cannot be protected from heat, and thus, the melting point is preferably 160°C or more. When the melting point is too high, handling may be difficult, and thus, the melting point is more preferably 160 to 175°C.

When the flexural modulus of the polyolefin-based resin composing the thermal buffer layer 12 is low, the melting point of the polyolefin-based resin tends to be too low, and thus the laminate sheet possibly cannot be protected from heat, and when the flexural modulus is high, handling may be difficult. Therefore, the flexural modulus is preferably 500 to 1500 MPa, and more preferably 700 to 1200 MPa. Here, the flexural modulus of the polyolefin-based resin refers to those measured in accordance with JIS K7127.

The method of laminating and integrating the sealing layer 11 on either side of the underside protective sheet for solar cell A is not particularly limited, and for example, the resin composition composing the sealing layer 11 is fed into an extruder and melt-kneaded, and extrusion-laminated on the either surface of the underside protective sheet for solar cell A, whereby the sealing layer 11 can be laminated and integrated on the underside protective sheet for solar cell A.

Alternatively, when the thermal buffer layer 12 is interposed between the underside protective sheet for solar cell A and the sealing layer 11, the thermal buffer layer 12 and the sealing layer 11 can be laminated and integrated on the underside protective sheet for solar cell by the following method.

First, while the polyolefin-based resin composing the thermal buffer layer 12 is fed into the first extruder and melt-kneaded, the resin composition composing the sealing layer 11 is fed into the second extruder and melt-kneaded, and then the two materials are co-extruded, whereby a stacked sheet in which the thermal buffer layer 12 and the sealing layer 11 are laminated and integrated is manufactured. Next, the stacked sheet is laminated and integrated on either side of the underside protective sheet for solar cell A using an all-purpose adhesive such that the thermal buffer layer 12 is opposite to the underside protective sheet for solar cell A, whereby the thermal buffer layer 12 and the sealing layer 11 can be laminated and integrated in this order on the underside protective sheet for solar cell.

The underside protective sheet for solar cell A having the sealing layer 11 can be suitably used as an underside protective sheet for solar cell when a solar cell module is manufactured using a thin film solar cell.

As shown in Fig. 12, a thin film solar cell C is composed such that a solar cell element 14 made of amorphous silicon, gallium-arsenic, copper-indium-selenium, a compound semiconductor, or the like, is laminated and integrated on a transparent substrate 13 in a thin film form.

The underside protective sheet for solar cell A is laminated and integrated on the side on which the solar cell element 14 is formed in the transparent substrate 13 of the thin film solar cell C, such that the sealing layer 11 is opposite to the transparent substrate 13, whereby the solar cell element 14 of the thin film solar cell C can be sealed by the underside protective sheet for solar cell A, and a solar cell module D can be manufactured (refer to Fig. 12).

The underside protective sheet for solar cell A of the above-described constitution can also be used as a gas-barrier film for various applications such as food applications and pharmaceutical applications, besides solar cell applications.

## EFFECTS OF THE INVENTION

The underside protective sheet for solar cell of the present invention has excellent moisture vapor proof properties since a composite base material itself contains plate-like inorganic particles in a dispersed state. A polymer having high heat resistance such as a cycloolefin resin or a liquid crystal resin is preferably selected, whereby the sheet has excellent dimensional stability, and causes almost no dimension change particularly even when used in a hot environment.

In addition, the sol-gel layer itself has excellent barrier properties, and when plate-like inorganic particles are contained in the sol-gel layer, the sol-gel layer exhibits further excellent gas barrier properties to oxygen and moisture vapor.

When the sol-gel layer of the underside protective sheet for solar cell A contains plate-like inorganic particles, the sol-gel layer is further improved in gas barrier properties by containing the plate-like inorganic particles in addition to its own excellent gas barrier properties. Therefore, the underside protective sheet for solar cell of the present invention exhibits excellent gas barrier properties to oxygen and moisture vapor, stably protects the solar cell element from the back side over a long period, and can stably maintain the performance of the solar cell module over a long period.

When the underside protective sheet for solar cell of the present invention has a vapor-deposited film, since the vapor-deposited film also has excellent barrier properties to oxygen and moisture vapor, the underside protective sheet for solar cell exhibits dramatically excellent gas barrier properties, stably protects the solar cell element from the back side over a long period, and can stably maintain the performance of the solar cell module over a long period.

The underside protective sheet for solar cell of the present invention does not use a metal foil such as an aluminum foil, and therefore, even when used as an underside protective sheet for solar cell, does not produce a damage such as short circuit on the solar cell element.

The underside protective sheet for solar cell in which a sealing layer is laminated and integrated on either side of the underside protective sheet for solar cell, and the sealing layer contains a modified polypropylene-based resin graft-modified with an unsaturated carboxylic acid or an anhydride thereof and having a melting point measured in accordance with JIS K7121 of 120 to 170°C and a silane compound represented by $R^2Si(OR^3)_3$, makes it possible to perform lamination with a solar cell by a roll to roll method, and to efficiently manufacture a solar cell module.

Furthermore, since the underside protective sheet for solar cell does not contain an organic peroxide, it does not require a crosslinking process by an organic peroxide unlike a conventional sealing material, and, enables efficient manufacture of a solar cell module, and also does not generate a decomposition product of the organic peroxide, can maintain adherence to the solar cell over a long period, and can stably maintain performance of solar cell over a long period.

When the underside protective sheet for solar cell of the present invention has a polyvinyl fluoride film layer or a fluorine-based coating layer as an outermost layer, excellent weatherability is exhibited, and durability of the underside protective sheet for solar cell is improved, and thus, the solar cell module can maintain stable performance over a long period.

When the underside protective sheet for solar cell of the present invention has an ethylene-vinyl acetate copolymer film layer as an outermost layer, the underside protective sheet for solar cell is laminated on the side opposite to the light-receiving surface of the solar cell element upon manufacturing a solar cell module, whereby the sealing material and the underside protective sheet for solar cell can be laminated and integrated on the back side of the solar cell element as one member, and workability upon manufacturing the solar cell module can be improved.

BRIEF DESCRIPTION OF THE DRAWINGS

[Fig. 1] Fig. 1 is a longitudinal sectional view showing the underside protective sheet for solar cell of the present invention.
[Fig. 2] Fig. 2 is a longitudinal sectional view showing another example of the underside protective sheet for solar cell of the present invention.
[Fig. 3] Fig. 3 is a longitudinal sectional view showing another example of the underside protective sheet for solar cell of the present invention.
[Fig. 4] Fig. 4 is a longitudinal sectional view showing another example of the underside protective sheet for solar cell of the present invention.
[Fig. 5] Fig. 5 is a schematic longitudinal sectional view showing one example of a solar cell module.
[Fig. 6] Fig. 6 is a longitudinal sectional view showing another example of the underside protective sheet for solar cell of the present invention.
[Fig. 7] Fig. 7 is a longitudinal sectional view showing another example of the underside protective sheet for solar cell of the present invention.
[Fig. 8] Fig. 8 is a longitudinal sectional view showing another example of the underside protective sheet for solar cell of the present invention.
[Fig. 9] Fig. 9 is a longitudinal sectional view showing another example of the underside protective sheet for solar cell of the present invention.

[Fig. 10] Fig. 10 is a longitudinal sectional view showing another example of the underside protective sheet for solar cell of the present invention.

[Fig. 11] Fig. 11 is a longitudinal sectional view showing another example of the underside protective sheet for solar cell of the present invention.

[Fig. 12] Fig. 12 is a longitudinal sectional view showing the solar cell module of the present invention.

MODES FOR CARRYING OUT THE INVENTION

Hereinafter, examples of the present invention will be described, but the present invention is not limited to these examples.

(Example 1)

15 parts by weight of plate-like boehmite microparticles (manufactured by Sasol, trade name "Disperal 60", average size: 60 nm, aspect ratio: 5) and 85 parts by weight of a polypropylene having a melt flow rate of 1.6 g/10 min (manufactured by Prime Polymer Co., Ltd., trade name "E203GV", melting point: 169°C) were mixed, and then the mixture was fed into a twin screw extruder (manufactured by Toshiba Machine Co., Ltd., trade name "TEM35B"), melt-kneaded at 250°C, and extruded at a discharge amount of 50 kg/hr, to obtain pellets. These pellets were melt-kneaded and extruded with an extruder, to obtain a composite base material with a thickness of 200 μm. This composite base material was subjected to a corona discharge treatment on one side, to form a corona-treated surface. Incidentally, in a polypropylene, the moisture vapor transmission rate measured in accordance with JIS K7126 at 23°C with a relative humidity of 90% at a thickness of 100 μm was 2.1 $g/m^2 \cdot day$.

A biaxially-stretched polyethylene terephthalate film with a thickness of 12 μm in which one side was a corona-treated surface was prepared. This biaxially-stretched polyethylene terephthalate film was ran while contacted with a cooling drum in a vapor-deposition chamber, silicon oxide (SiO) was vacuum vapor-deposited (vapor-deposition conditions: electron beam power (32 KV - 0.60 A), pressure of $1 \times 10^{-4}$ Torr) on the corona-treated surface of the biaxially-stretched polyethylene terephthalate film so as to have a thickness of 600 Å, to form a vapor-deposited film with a thickness of 600 Å.

15 parts by weight of ethyl silicate, 10 parts by weight of propanol, and 60 parts by weight of γ-glycidoxypropyltrimethoxysilane (manufactured by Dow Corning Toray Co., Ltd., trade name "SH6040") were mixed at a relative humidity of 30% and room temperature, and thereafter, 8 parts by weight of tetrabutoxytitanium was slowly added dropwise to this mixture while stirring at a relative humidity of 20% and room temperature. After completion of dropping of tetrabutoxytitanium, the mixture was further stirred for 2 hours, and thereafter, 0.5 parts by weight of a 0.001 N nitric acid aqueous solution was slowly added dropwise to the mixture. After completion of dropping of the nitric acid aqueous solution, the mixture was further stirred for 5 hours. 2 parts by weight of colloidal silica (manufacture by Catalysts & Chemicals Industries Co., Ltd., trade name "Cataloid S") was slowly added to this mixture, to prepare a sol solution.

This sol solution was applied to the vapor-deposited film of the biaxially-stretched polyethylene terephthalate film by gravure coating and dried at 125°C for 1 hour, to form a sol-gel layer with a thickness of 1.5 μm with a coating amount of 1.5 $g/m^2$ (dry condition).

An epoxy-based silane coupling agent was added to an initial condensate of a polyurethane-based resin so as to be 5.0% by weight, and the mixture was kneaded to prepare a primer resin composition, and this primer resin composition was applied to the above-described sol-gel layer by gravure roll coating and dried so as to be 0.6 $g/m^2$ (dry condition), to form a primer layer.

5 parts by weight of plate-like boehmite microparticles (manufactured by Sasol, trade name "Disperal 60", average size: 60 nm, aspect ratio: 5) were added to 100 parts by weight of a two-component curable urethane-based adhesive for lamination containing 1.8% by weight of a benzophenone-based ultraviolet absorber as an ultraviolet absorber and then mixed, to obtain a microparticles-containing adhesive for lamination. This microparticles-containing adhesive for lamination was applied to the primer layer by gravure roll coating so as to be 5 $g/m^2$ (dry condition), to form an adhesive layer for lamination.

The above-described composite base material was laminated and integrated on the adhesive layer for lamination with its corona-treated surface opposite to the adhesive layer for lamination by dry lamination, to obtain an underside protective sheet for solar cell.

A two-component curable urethane-based adhesive made from 100 parts by weight of a base compound (manufactured by Mitsui Chemicals Polyurethanes, Inc., trade name "TAKELAC A315") and 10 parts by weight of a curing agent (manufactured by Mitsui Chemicals Polyurethanes, Inc., trade name "TAKENATE A50") was prepared as an adhesive for dry lamination.

A fluorine-based resin sheet (ETFE) made from an ethylene-tetrafluoroethylene copolymer with a thickness of 50 μm was laminated and integrated on the biaxially-stretched polyethylene terephthalate film of the above-described

underside protective sheet for solar cell by dry lamination using the adhesive for dry lamination. Here, the urethane-based adhesive was used such that the application amount was 4.5 $g/m^2$ as a solid content.

Next, 100 parts by weight of an ethylene-vinyl acetate copolymer (content of vinyl acetate: 25% by weight, melt flow rate: 2.0 g/10 min), 1.5 parts by weight of a crosslinking agent, 0.2 parts by weight of a silane coupling agent and 2.0 parts by weight of a crosslinking aid were fed into an extruder, melt-kneaded, and an ethylene-vinyl acetate copolymer layer was extrusion-laminated with a thickness of 350 μm on the fluorine-based resin sheet of the underside protective sheet for solar cell.

Using the underside protective sheet for solar cell obtained as described above as an underside protective sheet for solar cell, a solar cell module was prepared in the following manner. A glass plate with a thickness of 3 mm, an ethylene-vinyl acetate copolymer sheet with a thickness of 400 μm, a solar cell element made of amorphous silicon, and an underside protective sheet for solar cell were laminated in this order and thermocompression-bonded at 150°C over a period of 15 minutes, thereby obtaining a solar cell module. Here, the underside protective sheet for solar cell was laminated such that the ethylene-vinyl acetate copolymer layer faces the side of the solar cell element.

(Example 2)

25 parts by weight of ethyl silicate, 10 parts by weight of ethanol, and 50 parts by weight of γ-glycidoxypropyltrimethoxysilane (manufactured by Dow Corning Toray Co., Ltd., trade name "SH6040") were mixed at a relative humidity of 30% and room temperature, and thereafter, 3.8 parts by weight of tri-sec-butoxyaluminum was slowly added dropwise to this mixture while stirring at a relative humidity of 20% and room temperature. After completion of dropping of tri-sec-butoxyaluminum, the mixture was further stirred for 2 hours, and thereafter, 0.5 parts by weight of a 0.001 N nitric acid aqueous solution was slowly added dropwise to the mixture. After completion of dropping of the nitric acid aqueous solution, the mixture was further stirred for 5 hours.

On the other hand, 30 parts by weight of plate-like boehmite microparticles (manufactured by Sasol, trade name "Disperal 60", average size: 60 nm, aspect ratio: 5) was added to 30 parts by weight of colloidal silica (manufacture by Catalysts & Chemicals Industries Co., Ltd., trade name "Cataloid S") and was subjected to ultrasonic dispersion over a period of 3 hours.

The colloidal silica in which the plate-like boehmite microparticles were dispersed was slowly added to the above-described mixture, to prepare a sol solution. The same procedure as in Example 1 was carried out except that this sol solution was used, to obtain an underside protective sheet for solar cell and a solar cell module.

(Example 3)

15 parts by weight of plate-like boehmite microparticles (manufactured by Sasol, trade name "Disperal 60", average size: 60 nm, aspect ratio: 5) and 85 parts by weight of a cyclic olefin (manufactured by ZEON CORPORATION, trade name "Zeonor 1600", glass-transition temperature: 163°C) were mixed, and then the mixture was fed into a twin screw extruder (manufactured by Toshiba Machine Co., Ltd., trade name "TEM35B"), melt-kneaded at 300°C, and extruded at a discharge amount of 30 kg/hr, to obtain pellets. These pellets were melt-kneaded and extruded with an extruder, to obtain a composite base material with a thickness of 200 μm. The same procedure as in Example 1 was carried out except that this composite base material was used, to obtain an underside protective sheet for solar cell and a solar cell module. Incidentally, in the cyclic olefin, the moisture vapor transmission rate measured in accordance with JIS K7126 at 23°C with a relative humidity of 90% at a thickness of 100 μm was 1.8 $g/m^2 \cdot day$.

(Example 4)

15 parts by weight of plate-like boehmite microparticles (manufactured by Sasol, trade name "Disperal 60", average size: 60 nm, aspect ratio: 5) and 85 parts by weight of a polypropylene having a melt flow rate of 1.6 g/10 min (manufactured by Prime Polymer Co., Ltd., trade name "E203GV", melting point: 169°C) were mixed, and then the mixture was fed into a twin screw extruder (manufactured by Toshiba Machine Co., Ltd., trade name "TEM35B"), melt-kneaded at 250°C, and extruded at a discharge amount of 50 kg/hr, to obtain pellets. These pellets were melt-kneaded and extruded with an extruder, to obtain a composite base material with a thickness of 200 μm. This composite base material was subjected to a corona discharge treatment on one side, to form a corona-treated surface. Incidentally, in a polypropylene, the moisture vapor transmission rate measured in accordance with JIS K7126 at 23°C with a relative humidity of 90% at a thickness of 100 μm was 2.1 $g/m^2 \cdot day$.

A biaxially-stretched polyethylene terephthalate film with a thickness of 12 μm in which one side was a corona-treated surface was prepared. This biaxially-stretched polyethylene terephthalate film was ran while contacted with a cooling drum in a vapor-deposition chamber, silicon oxide (SiO) was vacuum vapor-deposited (vapor-deposition conditions: electron beam power (32 KV - 0.60 A), pressure of $1 \times 10^{-4}$ Torr) on the corona-treated surface of the biaxially-stretched polyethylene terephthalate film so as to have a thickness of 600 Å, to form a vapor-deposited film with a thickness of 600 Å.

15 parts by weight of ethyl silicate, 10 parts by weight of propanol, and 60 parts by weight of γ-glycidoxypropyltrimethoxysilane (manufactured by Dow Corning Toray Co., Ltd., trade name "SH6040") were mixed at a relative humidity of 30% and room temperature, and thereafter, 8 parts by weight of tetrabutoxytitanium was slowly added dropwise to this mixture while stirring at a relative humidity of 20% and room temperature. After completion of dropping of tetrabutoxytitanium, the mixture was further stirred for 2 hours, and thereafter, 0.5 parts by weight of a 0.001 N nitric acid aqueous solution was slowly added dropwise to the mixture. After completion of dropping of the nitric acid aqueous solution, the mixture was further stirred for 5 hours. 2 parts by weight of colloidal silica (manufacture by Catalysts & Chemicals Industries Co., Ltd., trade name "Cataloid S") was slowly added to this mixture, to prepare a sol solution.

This sol solution was applied to a vapor-deposited film of the biaxially-stretched polyethylene terephthalate film by gravure coating and dried at 125°C for 1 hour, to form a sol-gel layer with a thickness of 1.5 μm with a coating amount of 1.5 g/$m^2$ (dry condition).

An epoxy-based silane coupling agent was added to an initial condensate of a polyurethane-based resin so as to be 5.0% by weight, and the mixture was kneaded to prepare a primer resin composition, and this primer resin composition was applied to the above-described sol-gel layer by gravure roll coating and dried so as to be 0.6 g/$m^2$ (dry condition), to form a primer layer.

5 parts by weight of plate-like boehmite microparticles (manufactured by Sasol, trade name "Disperal 60", average size: 60 nm, aspect ratio: 5) were added to 100 parts by weight of a two-component curable urethane-based adhesive for lamination containing 1.8% by weight of a benzophenone-based ultraviolet absorber as an ultraviolet absorber and then mixed, to obtain a microparticles-containing adhesive for lamination. This microparticles-containing adhesive for lamination was applied to the primer layer by gravure roll coating so as to be 5 g/$m^2$ (dry condition), to form an adhesive layer for lamination.

The above-described composite base material was laminated on the adhesive layer for lamination with its corona-treated surface opposite to the adhesive layer for lamination and laminated and integrated by dry lamination, to obtain an underside protective sheet for solar cell.

A two-component curable urethane-based adhesive for lamination made from 100 parts by weight of a base compound (manufactured by Mitsui Chemicals Polyurethanes, Inc., trade name "TAKELAC A315") and 10 parts by weight of a curing agent (manufactured by Mitsui Chemicals Polyurethanes, Inc., trade name "TAKENATE A50") was prepared as an adhesive for dry lamination.

100 parts by weight of the modified polypropylene-based resin (manufactured by Mitsui Chemicals, Inc., trade name "ADMER QE060", melting point: 142°C) and 3 parts by weight of vinyltrimethoxysilane were fed into an extruder and melt-kneaded, and extrusion-laminated from the extruder on the surface of the biaxially-stretched polyethylene terephthalate film of the underside protective sheet for solar cell in a sheet form, and a sealing layer with a thickness of 200 μm was laminated and integrated, to obtain an underside protective sheet for solar cell.

Next, an unhardened blue plate glass substrate with a thickness of 1.8 mm, on one surface of which a $SnO_2$ transparent conductive film had been formed by a thermal CVD method, was prepared as a transparent protective substrate. A single structured amorphous silicon semiconductor film with a pin element structure was formed on this unhardened blue plate glass substrate by a known plasma CVD method, and furthermore, a back electrode made of a ZnO transparent conductive film and a thin silver film was formed by known DC magnetron sputtering, to manufacture an amorphous silicon thin film solar cell.

Subsequently, the above-described underside protective sheet for solar cell was laminated on the side on which the single structured amorphous silicon semiconductor film was formed in the unhardened blue plate glass substrate of the amorphous silicon thin film solar cell, such that its sealing layer was opposite, to form a laminate, and this laminate was pressed by a roller in the thickness direction at 170°C, whereby the above-described underside protective sheet for solar cell was laminated and integrated on the side on which the single structured amorphous silicon semiconductor film was formed in the amorphous silicon thin film solar cell C, to obtain a solar cell module.

(Example 5)

An underside protective sheet for solar cell was manufactured in the same manner as in Example 4. Next, while 100 parts by weight of the modified polypropylene-based resin (manufactured by Mitsui Chemicals, Inc., trade name "ADMER QE060", melting point: 142°C) and 3 parts by weight of vinyltrimethoxysilane were fed into a first extruder as a composition composing a sealing layer, a polypropylene-based resin having a flexural modulus of 1200 MPa made from 80 parts by weight of a homopolypropylene having a melting point of 168°C and a flexural modulus of 1700 MPa and 20 parts by weight of a soft homopropylene having a melting point of 160°C and a flexural modulus of 550 MPa was fed into a second extruder as a composition composing a thermal buffer layer, and the compositions were co-extruded from a T die connected to both of the first and second extruders in a sheet form, to manufacture a stacked sheet in which

the sealing layer with a thickness of 80 μm and the thermal buffer layer with a thickness of 120 μm are laminated and integrated.

Next, the thermal buffer layer of the stacked sheet was subjected to a corona discharge treatment on the surface under the conditions of 6 KW and a treatment speed of 20 m/min, to adjust the surface tension on the film surface to 50 dyne/cm or more.

Thereafter, a two-component curable urethane-based adhesive for lamination containing 1.8% by weight of a benzophenone-based ultraviolet absorber was prepared, and this urethane-based adhesive for lamination was applied to the thermal buffer layer of the stacked sheet by a gravure roll coating method and dried so as to have a film thickness of 5.0 $g/m^2$ in a dry condition, to form an adhesive layer for lamination.

Incidentally, the two-component curable urethane-based adhesive for lamination was made from 100 parts by weight of a base compound (manufactured by Mitsui Chemicals Polyurethanes, Inc., trade name "TAKELAC A315") and 10 parts by weight of a curing agent (manufactured by Mitsui Chemicals Polyurethanes, Inc., trade name "TAKENATE A50").

The underside protective sheet for solar cell was laminated and integrated on the adhesive layer for lamination of the stacked sheet such that its biaxially-stretched polyethylene terephthalate film was opposite, to obtain an underside protective sheet for solar cell.

Next, an amorphous silicon thin film solar cell was manufactured in the same manner as in Example 4. The underside protective sheet for solar cell was laminated and integrated on the side on which the single structured amorphous silicon semiconductor film was formed in the amorphous silicon thin film solar cell in the same manner as in Example 4, to obtain a solar cell module.

(Example 6)

15 parts by weight of plate-like boehmite microparticles (manufactured by Sasol, trade name "Disperal 60") and 85 parts by weight of a cyclic olefin (manufactured by ZEON CORPORATION, trade name "Zeonor 1600", glass-transition temperature: 163°C) were mixed, and then the mixture was fed into a twin screw extruder (manufactured by Toshiba Machine Co., Ltd., trade name "TEM35B"), melt-kneaded at 300°C, and extruded at a discharge amount of 30 kg/hr, to obtain pellets. These pellets were melt-kneaded and extruded with an extruder, to obtain a composite base material with a thickness of 200 μm. The same procedure as in Example 5 was carried out except that this composite base material was used, to obtain an underside protective sheet for solar cell and a solar cell module. Incidentally, in the cyclic olefin, the moisture vapor transmission rate measured in accordance with JIS K7126 at 23°C with a relative humidity of 90% at a thickness of 100 μm was 1.8 $g/m^2 \cdot day$.

(Example 7)

The same procedure as in Example 6 was carried out except that a modified polypropylene-based resin (manufactured by Mitsubishi Chemical Corporation, trade name "MODIC P555", melting point: 134°C) was used as the modified polypropylene-based resin composing the sealing layer, to obtain an underside protective sheet for solar cell and a solar cell module.

(Example 8)

The same procedure as in Example 6 was carried out except that 100 parts by weight of a random polypropylene having a melting point of 143°C and a flexural modulus of 1200 MPa was used as the composition composing the thermal buffer layer, to obtain an underside protective sheet for solar cell and a solar cell module.

(Example 9)

The same procedure as in Example 4 was carried out except that vinyltrimethoxysilane was not contained in the sealing layer, to obtain an underside protective sheet for solar cell and a solar cell module.

(Example 10)

15 parts by weight of plate-like boehmite microparticles (manufactured by Sasol, trade name "Disperal 60", average size: 60 nm, aspect ratio: 5) and 85 parts by weight of a polypropylene having a melt flow rate of 1.6 g/10 min (manufactured by Prime Polymer Co., Ltd., trade name "E203GV", melting point: 169°C) were mixed, and then the mixture was fed into a twin screw extruder (manufactured by Toshiba Machine Co., Ltd., trade name "TEM35B"), melt-kneaded at 250°C, and extruded at a discharge amount of 50 kg/hr, to obtain pellets. These pellets were melt-kneaded

and extruded with an extruder, to obtain a composite base material with a thickness of 200 μm. This composite base material was subjected to a corona discharge treatment on one side, to form a corona-treated surface. Incidentally, in a polypropylene, the moisture vapor transmission rate measured in accordance with JIS K7126 at 23°C with a relative humidity of 90% at a thickness of 100 μm was 2.1 g/m$^2$·day.

25 parts by weight of ethyl silicate, 10 parts by weight of ethanol, and 50 parts by weight of γ-glycidoxypropyltrimethoxysilane (manufactured by Dow Corning Toray Co., Ltd., trade name "SH6040") were mixed at a relative humidity of 30% and room temperature, and thereafter, 3 parts by weight of tri-sec-butoxyaluminum was slowly added dropwise to this mixture while stirring at a relative humidity of 20% and room temperature. After completion of dropping of tri-sec-butoxyaluminum, the mixture was further stirred for 2 hours, and thereafter, 1.5 parts by weight of a 0.001 N nitric acid aqueous solution was slowly added dropwise to the mixture. After completion of dropping of the nitric acid aqueous solution, the mixture was further stirred for 5 hours.

On the other hand, 30 parts by weight of plate-like boehmite microparticles (manufactured by Sasol, trade name "Disperal 60", average size: 60 nm, aspect ratio: 5) was added to 30 parts by weight of colloidal silica (manufacture by Catalysts & Chemicals Industries Co., Ltd., trade name "Cataloid S") and was subjected to ultrasonic dispersion over a period of 3 hours.

The colloidal silica in which the plate-like boehmite microparticles were dispersed was slowly added to the above-described mixture, to prepare a sol solution. This sol solution was applied to the corona-treated surface of the composite base material by gravure coating and dried at 125°C for 1 hour, to form a sol-gel layer with a thickness of 3 μm with a coating amount of 2.8 g/m$^2$ (dry condition), whereby an underside protective sheet for solar cell was obtained.

A two-component curable urethane-based adhesive for lamination made from 100 parts by weight of a base compound (manufactured by Mitsui Chemicals Polyurethanes, Inc., trade name "TAKELAC A315") and 10 parts by weight of a curing agent (manufactured by Mitsui Chemicals Polyurethanes, Inc., trade name "TAKENATE A50") was prepared as an adhesive for dry lamination.

A fluorine-based resin sheet (ETFE) made from an ethylene-tetrafluoroethylene copolymer with a thickness of 50 μm was laminated and integrated on the sol-gel layer of the underside protective sheet for solar cell by dry lamination using the adhesive for dry lamination. Here, the adhesive for dry lamination was used such that the application amount was 4.5 g/m$^2$ as a solid content.

Next, 100 parts by weight of an ethylene-vinyl acetate copolymer (content of vinyl acetate: 25% by weight, melt flow rate: 2.0 g/10 min), 1.5 parts by weight of a crosslinking agent, 0.2 parts by weight of a silane coupling agent and 2.0 parts by weight of a crosslinking aid were fed into an extruder, melt-kneaded, and an ethylene-vinyl acetate copolymer layer was extrusion-laminated with a thickness of 350 μm on the fluorine-based resin sheet of the underside protective sheet for solar cell.

Using the underside protective sheet for solar cell obtained as described above as an underside protective sheet for solar cell, a solar cell module was prepared in the following manner. A glass plate with a thickness of 3 mm, an ethylene-vinyl acetate copolymer sheet with a thickness of 400 μm, a solar cell element made of amorphous silicon, and an underside protective sheet for solar cell were laminated in this order and thermocompression-bonded at 150°C over a period of 15 minutes, thereby obtaining a solar cell module. Here, the underside protective sheet for solar cell was laminated such that the ethylene-vinyl acetate copolymer layer faces the side of the solar cell element.

(Example 11)

15 parts by weight of plate-like boehmite microparticles (manufactured by Sasol, trade name "Disperal 60") and 85 parts by weight of a cyclic olefin (manufactured by ZEON CORPORATION, trade name "Zeonor 1600", glass-transition temperature: 163°C) were mixed, and then the mixture was fed into a twin screw extruder (manufactured by Toshiba Machine Co., Ltd., trade name "TEM35B"), melt-kneaded at 300°C, and extruded at a discharge amount of 30 kg/hr, to obtain pellets. These pellets were melt-kneaded and extruded with an extruder, to obtain a composite base material with a thickness of 200 μm. The same procedure as in Example 10 was carried out except that this composite base material was used, to obtain an underside protective sheet for solar cell and a solar cell module. Incidentally, in the cyclic olefin, the moisture vapor transmission rate measured in accordance with JIS K7126 at 23°C with a relative humidity of 90% at a thickness of 100 μm was 1.8 g/m$^2$·day.

(Example 12)

An underside protective sheet for solar cell was obtained in the same manner as in Example 10. 100 parts by weight of the modified polypropylene-based resin (manufactured by Mitsui Chemicals, Inc., trade name "ADMER QE060", melting point: 142°C) and 3 parts by weight of vinyltrimethoxysilane were fed into an extruder and melt-kneaded, and extrusion-laminated from the extruder on the surface of the sol-gel layer of the underside protective sheet for solar cell in a sheet form, and a sealing layer with a thickness of 200 μm was laminated and integrated, to obtain an underside

protective sheet for solar cell A.

Next, an unhardened blue plate glass substrate with a thickness of 1.8 mm, on one side of which a $SnO_2$ transparent conductive film had been formed by a thermal CVD method, was prepared as a transparent protective substrate. A single structured amorphous silicon semiconductor film with a pin element structure was formed on this unhardened blue plate glass substrate by a known plasma CVD method, and furthermore, a back electrode made of a ZnO transparent conductive film and a thin silver film was formed by known DC magnetron sputtering, to manufacture an amorphous silicon thin film solar cell C.

Subsequently, the above-described underside protective sheet for solar cell was laminated on the side on which the single structured amorphous silicon semiconductor film was formed in the unhardened blue plate glass substrate of the amorphous silicon thin film solar cell C, such that its sealing layer was opposite, to form a laminate, and this laminate was pressed by a roller in the thickness direction at 170°C, whereby the above-described underside protective sheet for solar cell was laminated and integrated on the side on which the single structured amorphous silicon semiconductor film was formed in the amorphous silicon thin film solar cell C, to obtain a solar cell module.

(Example 13)

An underside protective sheet for solar cell was obtained in the same manner as in Example 10. Next, while 100 parts by weight of the modified polypropylene-based resin (manufactured by Mitsui Chemicals, Inc., trade name "ADMER QE060", melting point: 142°C) and 3 parts by weight of vinyltrimethoxysilane were fed into a first extruder as a composition composing a sealing layer, a polypropylene-based resin having a flexural modulus of 1200 MPa made from 80 parts by weight of a homopolypropylene having a melting point of 168°C and a flexural modulus of 1700 MPa and 20 parts by weight of a soft homopropylene having a melting point of 160°C and a flexural modulus of 550 MPa was fed into a second extruder as a composition composing a thermal buffer layer, and the compositions were co-extruded from a T die connected to both of the first and second extruders in a sheet form, to manufacture a stacked sheet in which the sealing layer with a thickness of 80 μm and the thermal buffer layer with a thickness of 120 μm are laminated and integrated.

Next, the thermal buffer layer of the stacked sheet was subjected to a corona discharge treatment on the surface under the conditions of 6 KW and a treatment speed of 20 m/min, to adjust the surface tension on the film surface to 50 dyne/cm or more.

Thereafter, a two-component curable urethane-based adhesive for lamination containing 1.8% by weight of a benzophenone-based ultraviolet absorber was prepared, and this urethane-based adhesive for lamination was applied to the thermal buffer layer of the stacked sheet by a gravure roll coating method and dried so as to have a film thickness of 5.0 $g/m^2$ in a dry condition, to form an adhesive layer for lamination.

Incidentally, the two-component curable urethane-based adhesive for lamination was made from 100 parts by weight of a base compound (manufactured by Mitsui Chemicals Polyurethanes, Inc., trade name "TAKELAC A315") and 10 parts by weight of a curing agent (manufactured by Mitsui Chemicals Polyurethanes, Inc., trade name "TAKENATE A50").

The underside protective sheet for solar cell was laminated and integrated on the adhesive layer for lamination of the stacked sheet such that its sol-gel layer was opposite, to obtain an underside protective sheet for solar cell.

Next, an amorphous silicon thin film solar cell was manufactured in the same manner as in Example 12. The underside protective sheet for solar cell was laminated and integrated on the side on which the single structured amorphous silicon semiconductor film was formed in the amorphous silicon thin film solar cell in the same manner as in Example 12, to obtain a solar cell module.

(Example 14)

15 parts by weight of plate-like boehmite microparticles (manufactured by Sasol, trade name "Disperal 60") and 85 parts by weight of a cyclic olefin (manufactured by ZEON CORPORATION, trade name "Zeonor 1600", glass-transition temperature: 163°C) were mixed, and then the mixture was fed into a twin screw extruder (manufactured by Toshiba Machine Co., Ltd., trade name "TEM35B"), melt-kneaded at 300°C, and extruded at a discharge amount of 30 kg/hr, to obtain pellets. These pellets were melt-kneaded and extruded with an extruder, to obtain a composite base material with a thickness of 200 μm. The same procedure as in Example 13 was carried out except that this composite base material was used, to obtain an underside protective sheet for solar cell and a solar cell module. Incidentally, in the cyclic olefin, the moisture vapor transmission rate measured in accordance with JIS K7126 at 23°C with a relative humidity of 90% at a thickness of 100 μm was 1.8 g/m·day.

(Example 15)

The same procedure as in Example 14 was carried out except that a modified polypropylene-based resin (manufactured by Mitsubishi Chemical Corporation, trade name "MODIC P555", melting point: 134°C) was used as the modified polypropylene-based resin composing the sealing layer, to obtain an underside protective sheet for solar cell and a solar cell module.

(Example 16)

The same procedure as in Example 13 was carried out except that vinyltrimethoxysilane was not contained in the sealing layer, to obtain an underside protective sheet for solar cell and a solar cell module.

(Example 17)

The same procedure as in Example 12 was carried out except that 100 parts by weight of a random polypropylene having a melting point of 143°C and a flexural modulus of 1200 MPa was used as the composition composing the thermal buffer layer, to obtain an underside protective sheet for solar cell and a solar cell module.

(Comparative Example 1)

A glass plate with a thickness of 3 mm, an ethylene-vinyl acetate copolymer sheet with a thickness of 400 μm, a solar cell element made of amorphous silicon, an ethylene-vinyl acetate copolymer sheet with a thickness of 400 μm, and a white biaxially-stretched polyethylene terephthalate film with a thickness of 50 μm were laminated in this order and thermocompression-bonded at 150°C over a period of 15 minutes, to manufacture a solar cell module.

(Comparative Example 2)

A glass plate with a thickness of 3 mm, an ethylene-vinyl acetate copolymer sheet with a thickness of 400 μm, a solar cell element made of amorphous silicon, an ethylene-vinyl acetate copolymer sheet with a thickness of 400 μm, and a white polyvinyl fluoride resin sheet with a thickness of 50 μm were laminated in this order and thermocompression-bonded at 150°C over a period of 15 minutes, to manufacture a solar cell module.

(Comparative Example 3)

The same procedure as in Example 4 was carried out except that a white polyvinyl fluoride resin sheet with a thickness of 50 μm was used in place of the underside protective sheet for solar cell, to obtain an underside protective sheet for solar cell and a solar cell module.

For the underside protective sheets for a solar cell obtained in Examples 1 to 17 and Comparative Example 3, the white biaxially-stretched polyethylene terephthalate film used in Comparative Example 1, and the white polyvinyl fluoride resin sheet used in Comparative Example 2, the moisture vapor transmission rate was determined in the following manner, and the results are shown in Tables 1 and 2.

For the underside protective sheets for a solar cell obtained in Examples 1 to 3, 10, and 11, the white biaxially-stretched polyethylene terephthalate film used in Comparative Example 1, and the white polyvinyl fluoride resin sheet used in Comparative Example 2, the peel strength was determined in the following manner, and the results are shown in Table 4.

The output decreasing rates of the solar cell modules obtained in examples and comparative examples were determined in the following manner, and the results are shown in Tables 1 and 2.

Adhesion of the underside protective sheets for a solar cell obtained in Examples 1 to 17 and Comparative Examples 1 to 3 was determined in the following manner, and the results are shown in Table 5. Furthermore, lamination properties of the solar cell module obtained in Examples 4 to 9, 12 to 17, and Comparative Example 3 were determined in the following manner, and the results are shown in Table 2.

(Moisture Vapor Transmission Rate)

The moisture vapor transmission rates of the underside protective sheets for a solar cell obtained in Examples 1 to 17 and Comparative Example 3, the white biaxially-stretched polyethylene terephthalate film used in Comparative Example 1, and the white polyvinyl fluoride resin sheet used in Comparative Example 2 were determined using a commercially available measuring machine, trade name "GTR-100GW/30X" from GTR Tech Corporation, in accordance

with JIS K7126 under the conditions of a temperature of 40°C and a relative humidity of 90%.

(Peel Strength)

An underside protective sheet for solar cell was cut into a strip with a width of 15 mm to prepare a test piece, and peel strength of the underside protective sheet for solar cell was determined by a tensile testing machine (manufactured by A&D Company Limited., trade name "TENSILON") using this test piece.

(Output Decreasing Rate)

An environmental test of a solar cell module was performed based on JIS C8917-1989, and the output of photovoltaic power before and after the test was determined and calculated based on the following formula.

$$\text{Output Decreasing Rate (\%)} = 100 \times (\text{Output of Photovoltaic Power After Test} - \text{Output of Photovoltaic Power Before Test})/\text{Output of Photovoltaic Power Before Test}$$

(Initial Adhesion)

A test piece with a width of 20 mm was cut out from an underside protective sheet for solar cell. The test piece was adhered to a glass plate with its sealing layer or ethylene-vinyl acetate copolymer sheet, and a 90° peel test was performed at a tensile speed of 300 mm/min in accordance with JIS K6854 and the initial adhesion was evaluated based on the following criteria.

Good: While the tensile strength showed 19.6 N or more, the test piece could not be continuously peeled from the glass plate, and cohesive failure of the sealing layer or the ethylene-vinyl acetate copolymer layer occurred.
Poor: The tensile strength was 19.6 N or more, and the test piece could be continuously peeled from the glass plate.
Bad: The tensile strength was less than 19.6 N, and the test piece could be continuously peeled from the glass plate.

(Long-Lasting Adhesion)

A solar cell module was left under the environment of 85°C and a relative humidity of 85% over a period of 1000 hours, and thereafter, a 90° peel test was performed in accordance with JIS K6854 in the same manner as in the above-described adhesion and long-lasting adhesion was evaluated based on the following criteria. Incidentally, in Example 9 and Comparative Examples 1 and 2, the test piece spontaneously peeled.

Good: While the tensile strength showed 19.6 N or more, the test piece could not be continuously peeled from the glass plate, and cohesive failure of the ethylene-vinyl acetate copolymer layer occurred.
Poor: The tensile strength was 19.6 N or more, and the test piece could be continuously peeled from the glass plate.
Bad: The tensile strength was less than 19.6 N, and the test piece could be continuously peeled from the glass plate.

(Lamination Properties)

A plain square test flame with a side of 90 cm was formed on an arbitrary place on the unhardened blue plate glass substrate of the amorphous silicon thin film solar cell in the resulting solar cell module. In the test flame, the number of bubbles with a diameter of 1 mm or more, generated in the interface between the solar cell and the underside protective sheet for solar cell, was visually counted. 10 solar cell modules were prepared, and the arithmetic average value of the number of bubbles of each solar cell module was defined as the number of bubbles and lamination properties were evaluated based on the following criteria. Incidentally, in Comparative Example 3, when the solar cell and the underside protective sheet for solar cell were laminated and integrated, creases were generated on the underside protective sheet for solar cell. Therefore, the number of bubbles was not counted.

Good: No bubble was generated.
Poor: While a bubble was generated, the number was 2 or less.

Bad: More than 2 bubbles were generated.

[Table 1]

| | Moisture Vapor Transmission Rate(g/m$^2$·day) | Initial Adhesion | Long-Lasting Adhesion | Peel Strength (N/15 mm) | Output Decreasing Rate (%) |
|---|---|---|---|---|---|
| Example 1 | <0.01 | Good | Poor | 26 | 1 |
| Example 2 | <0.01 | Good | Poor | 25 | 1 |
| Example 3 | <0.01 | Good | Poor | 23 | 1 |
| Example 10 | 0.05 | Good | Poor | 20 | 3 |
| Example 11 | 0.03 | Good | Poor | 21 | 2 |
| Comparative Example 1 | 18.6 | Good | Bad | - | 13.6 |
| Comparative Example 2 | 32.8 | Good | Bad | - | 14.4 |

[Table 2]

| | Moisture Vapor Transmission Rate(g/m$^2$·day) | Initial Adhesion | Long-Lasting Adhesion | Lamination Properties | Output Decreasing Rate (%) |
|---|---|---|---|---|---|
| Example 4 | <0.01 | Good | Good | Good | 1 |
| Example 5 | <0.01 | Good | Good | Good | 1 |
| Example 6 | <0.01 | Good | Good | Good | 1 |
| Example 7 | <0.01 | Good | Good | Good | 1 |
| Example 8 | <0.01 | Good | Good | Creases were generated | 5.8 |
| Example 9 | <0.01 | Good | Bad | Good | 9.8 |
| Example 12 | 0.04 | Good | Good | Good | 3 |
| Example 13 | 0.02 | Good | Good | Good | 2 |
| Example 14 | 0.02 | Good | Good | Good | 2 |
| Example 15 | 0.02 | Good | Good | Good | 2 |
| Example 16 | 0.02 | Good | Bad | Good | - |
| Example 17 | 0.02 | Good | Good | Creases were generated | 6 |
| Comparative Example 3 | 35.1 | Good | Good | Good | 13.7 |

DESCRIPTION OF REFERENCE NUMERALS

1 Composite Base Material
2 Sol-Gel Layer

3 Vapor-Deposited Film
4 Base Material Film
5 Polyvinyl Fluoride Film Layer, Fluorine-Based Coating Layer
6 Solar Cell Element
7 Sealing Material
8 Sealing Material
9 Glass Plate
10 Ethylene-Vinyl Acetate Copolymer Film Layer
11 Sealing Layer
12 Thermal Buffer Layer
13 Transparent Substrate
14 Solar Cell Element
A Underside Protective Sheet for Solar Cell (Gas- barrier film)
B Solar Cell Module
C Thin Film Solar Cell
D Solar Cell Module

## Claims

1. An underside protective sheet for solar cell comprising a composite base material comprising a polymer having a moisture vapor transmission rate of 10 $g/m^2 \cdot day$ or less measured in accordance with JIS K7126 at 23°C with a relative humidity of 90% at a thickness of 100 μm, and plate-like inorganic particles, and a sol-gel layer that is laminated and integrated on the composite base material and formed by hardening one or more compounds selected from (A) to (C):

   (A) a silicon compound represented by $R^1_nSi(OX)_{4-n}$ or a hydrolysate thereof
   (B) an organometal compound represented by $M(OX)_m$ or a hydrolysate thereof
   (C) an alkali metal polysilicate

   wherein X independently represents an alkyl group having 1 to 6 carbon atoms or an acyl group having 1 to 6 carbon atoms, $R^1$ independently represents an alkyl group having 1 to 12 carbon atoms or a nonhydrolyzable functional group having polymerizability, M represents a metal atom, n represents 0 or an integer of 1 to 3, and m represents an integer of 2 to 4.

2. The underside protective sheet for solar cell according to claim 1, comprising a vapor-deposited film laminated and integrated on the sol-gel layer and a base material film laminated and integrated on the vapor-deposited film.

3. The underside protective sheet for solar cell according to claim 1, comprising a base material film laminated and integrated on the sol-gel layer and a vapor-deposited film laminated and integrated on the base material film.

4. The underside protective sheet for solar cell according to claim 1, wherein plate-like inorganic particles are contained in the sol-gel layer.

5. The underside protective sheet for solar cell according to claim 1, wherein a sealing layer is integrally laminated on the surface.

6. The underside protective sheet for solar cell according to claim 5, wherein the sealing layer comprises 100 parts by weight of a modified polyolefin-based resin and 0.001 to 20 parts by weight of a silane compound represented by $R^2Si(OR^3)_3$ wherein $R^2$ represents a nonhydrolyzable functional group having polymerizability and $R^3$ represents an alkyl group having 1 to 5 carbon atoms.

7. The underside protective sheet for solar cell according to claim 6, wherein the modified polyolefin-based resin is a modified polyolefin-based resin graft-modified with an unsaturated carboxylic acid or an anhydride thereof and having a melting point measured in accordance with JIS K7121 of 120 to 170°C.

8. The underside protective sheet for solar cell according to claim 6, wherein the modified polyolefin-based resin is a modified polypropylene-based resin graft-modified with an unsaturated carboxylic acid or an anhydride thereof and

having a melting point measured in accordance with JIS K7121 of 120 to 170°C.

**9.** The underside protective sheet for solar cell according to claim 6, wherein the modified polyolefin-based resin comprises a modified polypropylene-based resin that is an ethylene-propylene random copolymer containing 1 to 10% by weight of an ethylene component, graft-modified with an unsaturated carboxylic acid or an anhydride thereof, and has a total content of the unsaturated carboxylic acid or the anhydride thereof of 0.01 to 20% by weight.

**10.** The underside protective sheet for solar cell according to claim 6, wherein the modified polyolefin-based resin comprises a modified polypropylene-based resin that is a propylene-butene-ethylene terpolymer, graft-modified with an unsaturated carboxylic acid or an anhydride thereof, and has a total content of the unsaturated carboxylic acid or the anhydride thereof of 0.01 to 20% by weight.

**11.** The underside protective sheet for solar cell according to claim 5, wherein a thermal buffer layer comprising a polyolefin-based resin is interposed between the underside protective sheet for solar cell and the sealing layer, and the polyolefin-based resin has a melting point measured in accordance with JIS K7121 of 160°C or more and a flexural modulus of 500 to 1500 MPa.

**12.** The underside protective sheet for solar cell according to claim 1, having a polyvinyl fluoride film layer or a fluorine-based coating layer as an outermost layer.

**13.** A solar cell module comprised by laminating and integrating the underside protective sheet for solar cell according to claim 5 on one side of a transparent substrate in a thin film solar cell comprised by forming a solar cell element on one side of the transparent substrate in a thin film form with the sealing layer opposite to the solar cell element.

**14.** A gas-barrier film comprising a composite base material comprising a polymer having a moisture vapor transmission rate of 10 $g/m^2 \cdot day$ or less measured in accordance with JIS K7126 at 23°C with a relative humidity of 90% at a thickness of 100 $\mu m$, and plate-like inorganic particles, and a sol-gel layer that is laminated and integrated on the composite base material and formed by hardening one or more compounds selected from (A) to (C):

(A) a silicon compound represented by $R^1_nSi(OX)_{4-n}$ or a hydrolysate thereof
(B) an organometal compound represented by $M(OX)_m$ or a hydrolysate thereof
(C) an alkali metal polysilicate

wherein X independently represents an alkyl group having 1 to 6 carbon atoms or an acyl group having 1 to 6 carbon atoms, $R^1$ independently represents an alkyl group having 1 to 12 carbon atoms or a nonhydrolyzable functional group having polymerizability, M represents a metal atom, n represents 0 or an integer of 1 to 3, and m represents an integer of 2 to 4.

Fig.1

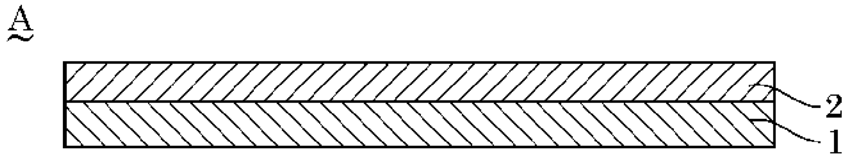


Fig.2

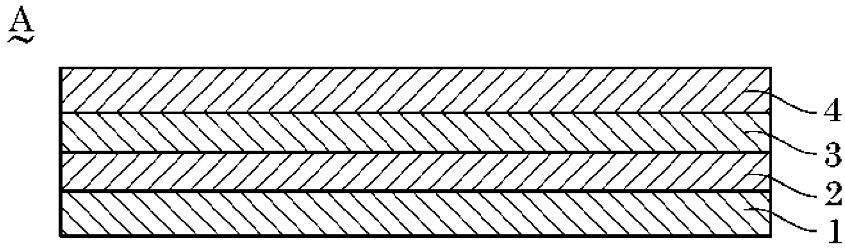


Fig.3

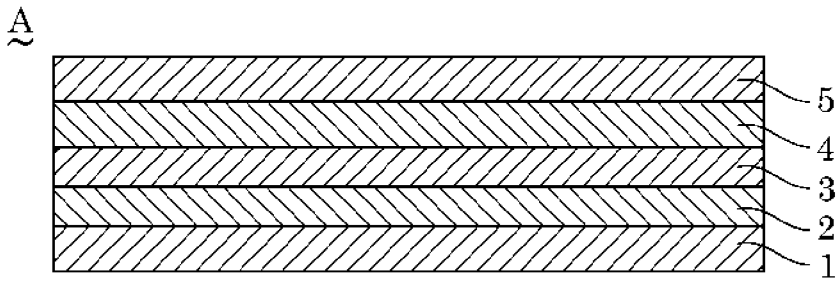


Fig.4

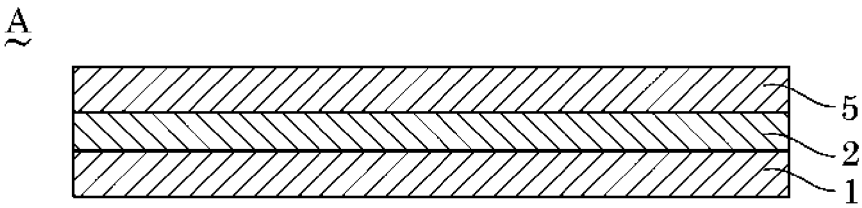

Fig.5

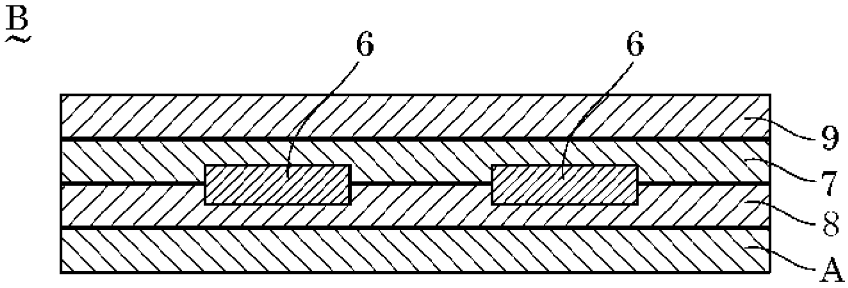


Fig.6

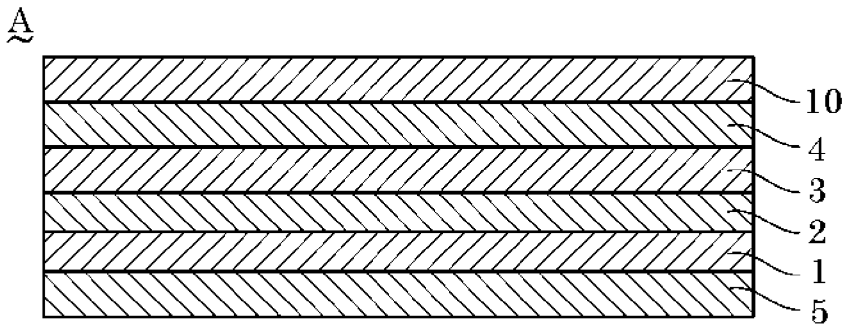


Fig.7

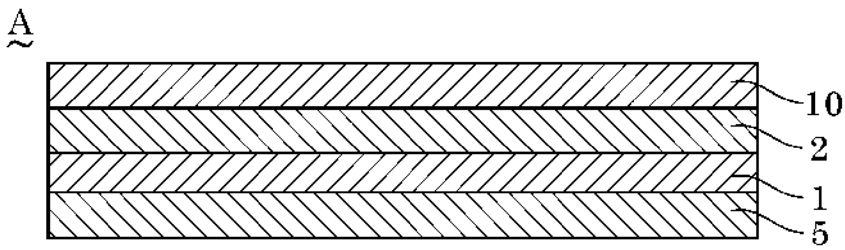


Fig.8

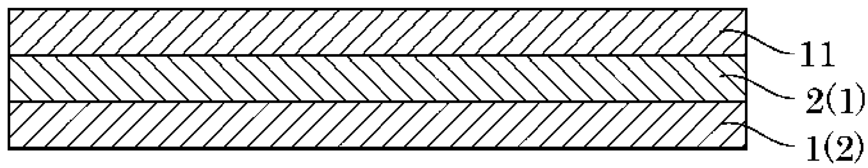

Fig.9

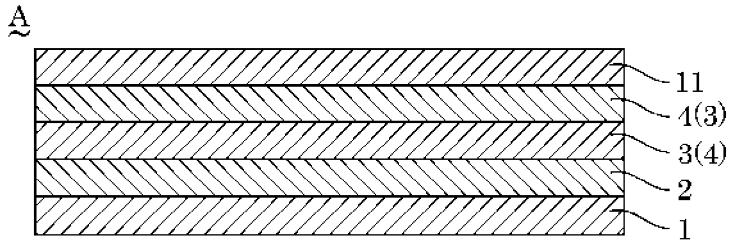


Fig.10

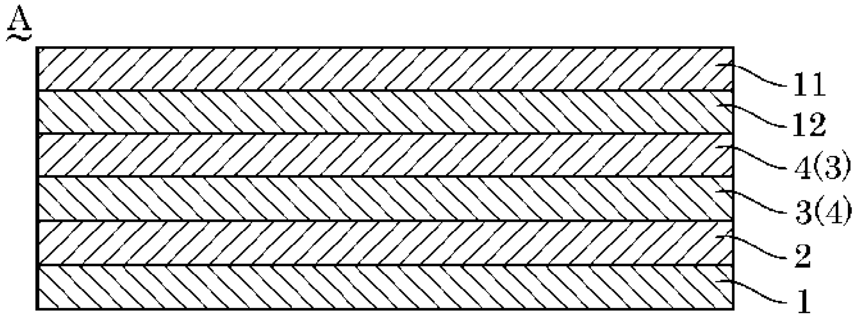


Fig.11

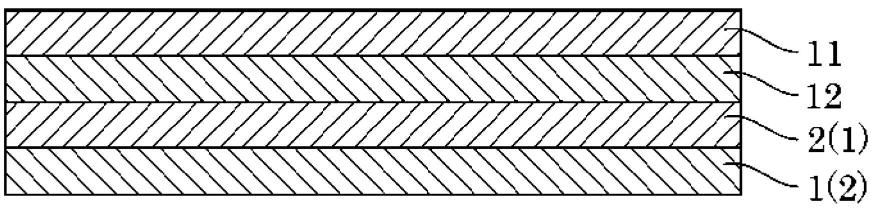


Fig.12

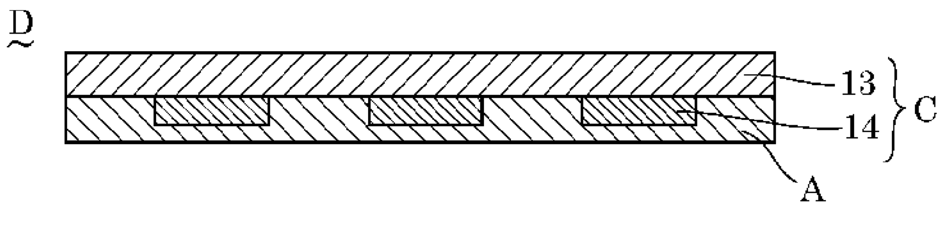

**INTERNATIONAL SEARCH REPORT**

International application No.
PCT/JP2010/053878

A. CLASSIFICATION OF SUBJECT MATTER
*H01L31/042*(2006.01)i

According to International Patent Classification (IPC) or to both national classification and IPC

B. FIELDS SEARCHED

Minimum documentation searched (classification system followed by classification symbols)
H01L31/042

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2005-320583 A (Konica Minolta Holdings, Inc.), 17 November 2005 (17.11.2005), paragraph [0002], [0103] to [0104] (Family: none) | 1-14 |
| Y | JP 2003-2641 A (Kawai Lime Industrial Co., Ltd.), 08 January 2003 (08.01.2003), paragraph [0001], [0012] to [0019] (Family: none) | 1-14 |
| Y | JP 2004-277219 A (Kawai Lime Industrial Co., Ltd.), 07 October 2004 (07.10.2004), paragraphs [0052] to [0054] (Family: none) | 1-14 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 14 June, 2010 (14.06.10) | 29 June, 2010 (29.06.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2010/053878

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2008-247931 A (Teijin Fibers Ltd.), 16 October 2008 (16.10.2008), paragraph [0027] (Family: none) | 1-14 |
| Y | JP 2000-114564 A (Dainippon Printing Co., Ltd.), 21 April 2000 (21.04.2000), paragraphs [0005] to [0037], [0047] to [0049] (Family: none) | 1-14 |
| Y | JP 2002-100788 A (Mitsubishi Aluminum Co., Ltd.), 05 April 2002 (05.04.2002), paragraphs [0008] to [0023] (Family: none) | 1-14 |
| Y | JP 2006-294780 A (Toppan Printing Co., Ltd.), 26 October 2006 (26.10.2006), paragraphs [0030] to [0057] (Family: none) | 1-14 |
| Y | JP 2006-120972 A (Toppan Printing Co., Ltd.), 11 May 2006 (11.05.2006), paragraph [0021] (Family: none) | 1-14 |
| Y | JP 2001-326374 A (Dainippon Printing Co., Ltd.), 22 November 2001 (22.11.2001), paragraphs [0004] to [0078] (Family: none) | 6-10 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H08176326 B
- JP 2002100788 A
- JP S5180400 B
- JP S6026024 B
- JP H01168725 B
- JP H01190726 B
- JP H0314882 B
- JP H03122137 B
- JP H0463807 B